(19)

Europäisches Patentamt
European Patent Office
Office européen des brevets

(11) **EP 4 567 897 A1**

(12) **EUROPEAN PATENT APPLICATION**

(43) Date of publication:
**11.06.2025 Bulletin 2025/24**

(21) Application number: **24180793.2**

(22) Date of filing: **07.06.2024**

(51) International Patent Classification (IPC):
**H01L 29/24** (2006.01)    **H01L 29/66** (2006.01)
**H01L 29/51** (2006.01)    **H01L 29/78** (2006.01)
**H01L 31/113** (2006.01)

(52) Cooperative Patent Classification (CPC):
**H10D 30/701; H10D 30/0415; H10F 30/282;**
B82Y 10/00; H10B 51/30; H10D 30/481;
H10D 62/881; H10D 62/883; H10D 64/689

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **04.12.2023  KR 20230173016
04.12.2023  KR 20230173071
04.12.2023  KR 20230173073
29.02.2024  KR 20240029733**

(71) Applicant: **Research & Business Foundation
Sungkyunkwan
University
Suwon-si, Gyeonggi-do 16419 (KR)**

(72) Inventors:
• **LEE, Sung Joo
13531 Gyeonggi-do (KR)**
• **BAEK, Sung Pyo
16417 Gyeonggi-do (KR)**

• **LEE, Yoon Myung
13523 Gyeonggi-do (KR)**
• **DAS, Biswajit
16362 Gyeonggi-do (KR)**
• **CHOI, Hae Ju
16421 Gyeonggi-do (KR)**
• **KANG, Tae Ho
07018 Seoul (KR)**
• **LEE, Sang Min
16322 Gyeonggi-do (KR)**
• **JANG, Cheol Hwa
16419 Gyeonggi-do (KR)**
• **NOH, Jong Min
16418 Gyeonggi-do (KR)**
• **KANG, Seong Kweon
16421 Gyeonggi-do (KR)**
• **LEE, Na Yeong
16417 Gyeonggi-do (KR)**

(74) Representative: **Dr. Gassner & Partner mbB
Wetterkreuz 3
91058 Erlangen (DE)**

(54) **HETEROJUNCTION STRUCTURE DEVICE AND ITS MANUFACTURING METHOD, FIELD EFFECT TRANSISTOR USING THE SAME, ARTIFICIAL VISUAL SYSTEM USING THE SAME, SOLAR CELL USING THE SAME, GAS SENSOR USING THE SAME, AND PIEZOELECTRIC ELEMENT USING THE SAME**

(57)    Provided is a heterojunction structure device. The heterojunction structure device includes: a gate electrode (200) disposed on a substrate (100); a ferroelectric layer (300) disposed on the gate electrode and including a material having ferroelectric characteristics; an insulating layer (400) on the ferroelectric layer; a channel layer (500) disposed on the insulating layer and including a material having ferroelectric and semiconductor characteristics; and a source electrode (S) and a drain electrode (D) disposed on the channel layer while being spaced apart from each other.

[Fig. 5]

S160

EP 4 567 897 A1

**Description**

BACKGROUND OF THE INVENTION

1. Field of the Invention

The present application relates to a heterojunction structure device and a method for manufacturing the same, and more specifically, to a heterojunction structure device having a structure in which mutually different ferroelectric materials are bonded and a method for manufacturing the same.

The heterojunction structure device and a method for manufacturing the same according to an embodiment of the present application may be applied to a field effect transistor, an artificial visual system, a solar cell, a gas sensor, and a piezoelectric device.

2. Description of the Related Art

The most complex biological organ is the human brain. Therefore, it is essential to study the brain-inspired biological neural networks (BNN) to build a system that imitates human abilities. More than 80% of the external senses are transmitted to the retina through optical stimulation, and these senses are detected, processed, and stored inside the brain through the BNN. An artificial neural networks (ANN) has recently attracted more attention than algorithm-based digital logic computing because low power consumption, self-learning, and logic inference tasks closely imitate structural and functional characteristics of the BNN.

The existing conventional complementary metal-oxide-semiconductor (CMOS) image sensors and charge-coupled device (CCD) cameras capable of detecting and processing optical signals are widely used digital image capturing apparatuses. However, the monolithic CMOS image sensor cannot detect a wide (Vis-NIR) wavelength range. Further, the existing digital image sensor is composed of three modules, i.e., a CMOS photo sensor, a signal processing apparatus, and an electronic memristor, and solves a structured problem based on a CMOS logic operation and processes a data set. However, such an apparatus consumes a considerable amount of power, is too large to be actually applied, resulting in a lot of cost. Moreover, since the future Internet of Things (IoT) will have greater performance requirements, artificial intelligence cannot meet the demands of low power consumption and high response between separate memory and processing apparatuses. On the other hand, the neuromorphic vision system inspired by the BNN can integrate a wide range of image sensing, learning, reasoning, and memory tasks into a single apparatus through self-learning and self-adaptation, thereby overcoming the disadvantages of the existing digital computing system.

In recent decades, artificial vision systems having various device structures such as diodes, resistive memories, and field effect transistors (FETs) have been developed by integrating various optical sensing and synaptic devices. In order to develop such an artificial vision system, many materials such as transition metal dichalcogenide, carbon nitride, perovskite, organic materials, etc., have been tested.

Since the optical response of such a system is mostly handled by band-to-band transition or trapping of excited electrons, the apparatus have the disadvantage of mainly responding to a single wavelength or operating with a narrow bandwidth and a complex apparatus configuration.

To overcome the above-described disadvantages and detect multicolor light without filtering in a single apparatus, different strategies are needed. In addition, in order to reduce complexity of an apparatus structure and control an influence of incident light on a gate voltage, a three-terminal structure based on a minimum number of transistors is required, and accordingly, various processing operations may be performed in a single apparatus.

Ferroelectrics have received considerable attention due to spontaneous electric dipole polarization and movement of domain walls under external electric field, mechanical deformation, or light irradiation. Oxide ferroelectrics based on a ABO3 structure are generally studied because of spontaneous polarization caused by distortion of off-center B ions. In addition to these oxide ferroelectrics, Van Der Waals (vdW) layered ferroelectrics (CIPS, $\alpha$-In$_2$Se$_3$, SnS, InSe, and 1T WTe$_2$) have led to paradigm shifts in basic research and technical fields due to small sizes (thin layers in atomic units), individual dipoles capable of overcoming a depolarization field, and strong ferromagnetic coupling between dipoles.

Among these 2D ferroelectrics, $\alpha$-In$_2$Se$_3$ has a characteristic in which in-plane (IP) polarization and out-of-plane (OOP) polarization coexist due to a five-layer structure in which interlayer Se atoms can be easily displaced left and right in the crystal. Therefore, various studies on $\alpha$-In$_2$Se$_3$ has been conducted.

For example, 'Dutta, D.; Mukherjee, S.; Uzhansky, M.; Koren, E. Cross-field optoelectronic modulation via inter-coupled ferroelectricity in 2D In2Se3. npj 2D Materials and Applications 2021' has experimentally demonstrated that these dipoles are locked in both directions inside controlled by a vertical gate voltage.

For another example, 'Rubio-Marcos, F.; Ochoa, D. A.; Del Campo, A.; Garcia, M. A.; Castro, G. R.; Fernandez, J. F.; Garcia, J. E. Reversible optical control of macroscopic polarization in ferroelectrics. Nature Photonics 2017' has suggested the possibility of switching the polarization region in a non-contact manner and remote manner by finding the polarity order change due to light in the ferroelectric.

For still another example, 'Xue, F.; He, X.; Liu, W.; Periyanagounder, D.; Zhang, C.; Chen, M.; Lin, C. H.; Luo, L.; Yengel, E.; Tung, V.; et al. Optoelectronic Ferroelectric Domain-Wall Memories Made from a Single Van Der Waals Ferroelectric. Advanced Functional Materials 2020' has demonstrated the memory effect due to the movement of the ferroelectric region wall controlled by the external optical illumination of the $\alpha$-In$_2$Se$_3$ element.

Accordingly, the present application is intended to propose a device having a heterojunction structure and capable of performing all of optical signal sensing, processing, and memory within a single device based on the $\alpha$-In2Se3 ferroelectric in order to develop an artificial vision system.

[Related Art Document]

[Non-Patent Documents]

Dutta, D.; Mukherjee, S.; Uzhansky, M.; Koren, E. Cross-field optoelectronic modulation via inter-coupled ferroelectricity in 2D In2Se3. npj 2D Materials and Applications 2021, 5 (1).

Rubio-Marcos, F.; Ochoa, D. A.; Del Campo, A.; Garcia, M. A.; Castro, G. R.; Fernandez, J. F.; Garcia, J. E. Reversible optical control of macroscopic polarization in ferroelectrics. Nature Photonics 2017, 12 (1), 29-32. DOI: 10.1038/s41566-017-0068-1.

Xue, F.; He, X.; Liu, W.; Periyanagounder, D.; Zhang, C.; Chen, M.; Lin, C. H.; Luo, L.; Yengel, E.; Tung, V.; et al. Optoelectronic Ferroelectric Domain-Wall Memories Made from a Single Van Der Waals Ferroelectric. Advanced Functional Materials 2020, 30 (52).

SUMMARY OF THE INVENTION

One technical problem to be solved by the present invention is to provide a heterojunction structure device in which mutually different ferroelectric material layers are bonded, and a method for manufacturing the same.

Another technical problem to be solved by the present invention is to provide a heterojunction structure device capable of controlling polarization of a channel layer by light irradiated to the channel layer, and a method for manufacturing the same.

Still another technical problem to be solved by the present invention is to provide a heterojunction structure device capable of controlling polarization of a ferroelectric layer by a voltage applied to a gate electrode, and a method for manufacturing the same.

Still another technical problem to be solved by the present invention is to provide a heterojunction structure device capable of controlling polarization of a channel layer by a voltage applied to a gate electrode, and a method for manufacturing the same.

Still another technical problem to be solved by the present invention is to provide a heterojunction structure device capable of performing all detecting, processing, and memorizing of external signals (optical signals and electrical signals) in a single device, and a method for manufacturing the same.

Still another technical problem to be solved by the present invention is to provide a heterojunction structure device capable of detecting optical signals in a wide wavelength range, and a method for manufacturing the same.

Still another technical problem to be solved by the present invention is to provide a heterojunction structure device capable of detecting optical signals of weak intensity, and a method for manufacturing the same.

Still another technical problem to be solved by the present invention is to provide a field effect transistor to which the above-described heterojunction structure device is applied.

Still another technical problem to be solved by the present invention is to provide an artificial visual system to which the above-described heterojunction structure device is applied.

Still another technical problem to be solved by the present invention is to provide a solar cell to which the above-described heterojunction structure device is applied.

Still another technical problem to be solved by the present invention is to provide a gas sensor to which the above-described heterojunction structure device is applied.

Still another technical problem to be solved by the present invention is to provide a piezoelectric device to which the above-described heterojunction structure device is applied.

The technical problems to be solved by the present invention are not limited to those described above.

In order to solve the above-described technical problems, the present invention provides a heterojunction structure device.

According to one embodiment, the heterojunction structure device may include: a gate electrode disposed on a substrate; a ferroelectric layer disposed on the gate electrode and including hafnium zirconium oxide (HZO); a channel layer disposed on the ferroelectric layer and including alpha-indium selenide ($\alpha$-In$_2$Se$_3$); and a source electrode and a drain electrode disposed on the channel layer while being spaced apart from each other.

According to one embodiment, the heterojunction structure device may further include an insulating layer disposed between the ferroelectric layer and the channel layer.

According to one embodiment, the insulating layer may include aluminum oxide ($Al_2O_3$).

According to one embodiment, in the heterojunction structure device, polarization of the channel layer may be controlled by light irradiated to the channel layer.

According to one embodiment, in the heterojunction structure device, polarization of the ferroelectric layer may be controlled by a voltage applied to the gate electrode.

According to another embodiment, the heterojunction structure device may include: a gate electrode disposed on a substrate; a ferroelectric layer disposed on the gate electrode and including a material having ferroelectric characteristics; a channel layer disposed on the ferroelectric layer and including a material having ferroelectric and semiconductor characteristics; and a source electrode and a drain electrode disposed on the channel layer while being spaced apart from each other.

According to another embodiment, the ferroelectric layer may include a material having out-of-plane (OOP) polarization characteristics.

According to another embodiment, the channel layer may include a material having both out-of-plane (OOP) polarization characteristics and in-plane (IP) polarization characteristics.

According to another embodiment, the ferroelectric layer may include any one of hafnium zirconium oxide (HZO), arsenic (As), antimony (Sb), bismuth (Bi), tellurium (Te), d1T-$MoS_2$, t-$MoS_2$, $WS_2$, $WSe_2$, $WTe_2$, BiN, SbN, BiP, GaN, GaSe, SiC, BN, AlN, ZnO, GeS, GeSe, SnS, SnSe, SiTE, GeTe, SnTE, PbTe, CrN, $CrB_2$, $CrBr_3$, $CrI_3$, GaTeCl, $AgBiP_2Se_6$, $CuCrP_2S_6$, $CuCrP_2S_6$, $CuVP_2S_6$, $CuVP_2Se_6$, $CuInP_2Se_6$, $CuInP_2S_6$(CIPS), $Sc_2CO_2$, $Bi_2O_2Se$, $Bi_2O_2Te$, $Bi_2O_2s$, $Ba_2PbCl_4$, graphanol, hydroxyl-functionalized graphene, halogen-decorated phosphorene, g-$C_6N_8H$, and Bi-$CH_2OH$.

According to another embodiment, the channel layer may include any one of alpha-indium selenide ($\alpha$-$In_2Se_3$), 1T-$MoS_2$, MoSSe, MoTe, SnS, SnSe, SnTe, GeS, GeSe, and GeTe.

According to another embodiment, in the heterojunction structure device, polarization of the channel layer may be controlled by light irradiated to the channel layer.

According to another embodiment, in the heterojunction structure device, polarization of the ferroelectric layer may be controlled by a voltage applied to the gate electrode.

According to still another embodiment, the heterojunction structure device may include: a gate electrode disposed on a substrate; a ferroelectric layer disposed on the gate electrode and including a material having ferroelectric characteristics; an insulating layer disposed on the ferroelectric layer; a channel layer disposed on the insulating layer and including a material having ferroelectric and semiconductor characteristics; and a source electrode and a drain electrode disposed on the channel layer while being spaced apart from each other.

According to still another embodiment, the insulating layer may include aluminum oxide ($Al_2O_2$), silicon oxide ($SiO_2$), hafnium oxide ($HfO_2$), and hexagonal boron nitride (h-BN) .

In order to solve the above-described technical problems, the present invention provides a method for manufacturing a heterojunction structure device.

According to one embodiment, the method for manufacturing a heterojunction structure device may include: preparing a substrate; forming a gate electrode on the substrate; forming a ferroelectric layer including a material having ferroelectric characteristics on the gate electrode; forming an insulating layer on the ferroelectric layer; forming a channel layer including a material having ferroelectric and semiconductor characteristics on the insulating layer; and forming a source electrode and a drain electrode on the channel layer such that the source electrode and the drain electrode are spaced apart from each other.

In the heterojunction structure device according to the embodiment of the present invention, polarization of the channel layer may be controlled by light irradiated to the channel layer ($\alpha$-$In_2Se_3$), and polarization of the ferroelectric layer may be controlled by a voltage applied to the gate electrode. Accordingly, the heterojunction structure device may perform all of detecting, processing, and memorizing of external signals (optical signals and electrical signals) in a single device. Therefore, the heterojunction structure device may be easily applied to an artificial visual system.

In addition, the heterojunction structure device may detect light in a wide wavelength range (for example, 405 nm to 850 nm) and light having very low intensity (0.03 mW/cm$^3$) due to intrinsic polarization characteristics (bidirectional polarization characteristics in which in-plane polarization and out-of-plane polarization are connected to each other) of the channel layer ($\alpha$-$In_2Se_3$).

In addition, the heterojunction structure device may implement paired pulse facilitation (PPF), which is electrical characteristics that an artificial synapse device necessarily have, and characteristics of transition from short term memory (STM) to long term memory (LTM), and may perform logic operations such as pattern recognition, light adaptation training, Pavlov's training, and the like.

# EP 4 567 897 A1

BRIEF DESCRIPTION OF THE DRAWINGS

FIG. 1 is a flowchart for explaining a method for manufacturing a heterojunction structure device according to an embodiment of the present invention.

FIG. 2 is a schematic view for explaining step S110 and step S120 in the method for manufacturing a heterojunction structure device according to the embodiment of the present invention.

FIG. 3 is a schematic view for explaining step S130 and step S140 in the method for manufacturing a heterojunction structure device according to the embodiment of the present invention.

FIG. 4 is a schematic view for explaining step S150 in the method for manufacturing a heterojunction structure device according to the embodiment of the present invention.

FIG. 5 is a schematic view for explaining step S160 in the method for manufacturing a heterojunction structure device according to the embodiment of the present invention.

FIG. 6 is a schematic view for explaining step S210 in a method for manufacturing an artificial synapse device according to a first modification example of the present invention.

FIG. 7 is a schematic view for explaining step S220 in the method for manufacturing an artificial synapse device according to the first modification example of the present invention.

FIG. 8 is a schematic view for explaining step S230 in the method for manufacturing an artificial synapse device according to the first modification example of the present invention.

FIG. 9 is a schematic view for explaining step S340 in a method for manufacturing an artificial synapse device according to a second modification example of the present invention.

FIG. 10 is a schematic view for explaining step S350 in the method for manufacturing an artificial synapse device according to the second modification example of the present invention.

FIG. 11 is a schematic view for explaining step S360 in the method for manufacturing an artificial synapse device according to the second modification example of the present invention.

FIG. 12 is a schematic view for explaining step S370 in a method for manufacturing an artificial synapse device according to a second modification example of the present invention.

FIG. 13 is a schematic sectional view of a ferroelectric field effect transistor according to a third modification example of the present invention.

FIG. 14 is a schematic plan view of the ferroelectric field effect transistor according to the third modification example of the present invention.

FIG. 15 is a schematic view for explaining a method for manufacturing a Fe FET device according to an experimental example of the present invention.

FIG. 16 is a schematic view for explaining the Fe FET device according to the experimental example of the present invention.

FIG. 17 is a view for explaining an AFM analysis result of a ferroelectric layer of the Fe FET device according to the experimental example of the present invention.

FIG. 18 is a view for explaining an AFM analysis result of an insulating layer of the Fe FET device according to the experimental example of the present invention.

FIG. 19 is a view for explaining an AFM analysis result of a channel layer of the Fe FET device according to the experimental example of the present invention.

FIG. 20 is a view for explaining a Raman analysis result of a heterojunction structure of the Fe FET device according to the experimental example of the present invention.

FIG. 21 is a view for explaining a TEM image and an EDS mapping image for the heterojunction structure of the Fe FET device according to the experimental example of the present invention.

FIG. 22 is a view showing a position in which AFM scanning is used to confirm an operation of the Fe FET device according to the experimental example of the present invention.

FIG. 23 is a view showing a surface potential measured in the channel layer between a source electrode and a drain electrode when a negative voltage is applied to a gate electrode.

FIG. 24 is a view showing a surface potential measured in the channel layer between the source electrode and the drain electrode when a positive voltage is applied to the gate electrode.

FIG. 25 is a view showing a PFM phase image under a dark condition.

FIG. 26 is a view showing a PFM phase value measured when voltages having opposite polarities are applied to the gate electrode under the dark condition.

FIG. 27 is a view showing a schematic view of dipole polarization under the dark condition.

FIG. 28 is a view showing a PFM phase image under a light condition.

FIG. 29 is a view showing a PFM phase value measured when voltages having opposite polarities are applied to the gate electrode under the light condition.

FIG. 30 is a view showing a schematic view of dipole polarization under the light condition.

FIG. 31 is a view for explaining voltage-current characteristics of the Fe FET device according to the experimental example of the present invention.

FIG. 32 is a view for explaining voltage-current characteristics of a Fe FET device according to a comparative example of the present invention.

FIG. 33 is a view for explaining a change in transfer characteristics according to a scanning voltage range of the Fe FET device according to the experimental example of the present invention.

FIG. 34 is a view for explaining a change in transfer characteristics according to a change in a read voltage of the Fe FET device according to the experimental example of the present invention.

FIG. 35 is a view for explaining an on/off ratio of the Fe FET device according to the experimental example of the present invention.

FIG. 36 is a view for explaining a memory window of the Fe FET device according to the experimental example of the present invention.

FIG. 37 is a view for explaining output characteristics of the Fe FET device according to the experimental example of the present invention.

FIG. 38 is a view showing a schematic view of electrical synapse measurement using the Fe FET device according to the experimental example of the present invention.

FIG. 39 is a view for explaining a short-term depression effect of the Fe FET device according to the experimental example of the present invention.

FIG. 40 is a view for explaining a short-term potentiation effect of the Fe FET device according to the experimental example of the present invention.

FIG. 41 is a view showing a model for signal detection and information memory processes.

FIG. 42 is a view for explaining a current voltage according to the number of signals input to the Fe FET device according to the experimental example of the present invention.

FIG. 43 is a view for explaining a normalized attenuation current value according to the number of signals input to the Fe FET device according to the experimental example of the present invention.

FIG. 44 is a view for explaining transition from a short term memory to a long term memory through the Fe FET device according to the experimental example of the present invention.

FIG. 45 is a view for explaining a PPF analysis result of the Fe FET device according to the experimental example of the present invention.

FIGS. 46 to 49 are views for explaining a PPF ratio of the Fe FET device according to the experimental example of the present invention.

FIG. 50 is a view showing a fast relaxation time and a slow relaxation time of attenuation curves for various wavelengths.

FIG. 51 is a view for explaining an effect of an electric field on the Fe FET device under a condition in which light having a wavelength of 405 nm is irradiated.

FIG. 52 is a view for explaining an effect of the electric field on the Fe FET device under a condition in which light having a wavelength of 655 nm is irradiated.

FIG. 53 is a view for explaining an effect of the electric field on the Fe FET device under a condition in which light having a wavelength of 785 nm is irradiated.

FIG. 54 is a view for explaining an effect of the electric field on the Fe FET device under a condition in which light having a wavelength of 850 nm is irradiated.

FIGS. 55 to 58 are views for explaining synaptic weight update characteristics of the Fe FET device according to the experimental example of the present invention.

FIG. 59 is a view for explaining long-term stability for the synaptic weight update characteristics of the Fe FET device according to the experimental example of the present invention.

FIG. 60 is a schematic view of an ANN for recognizing a MNIST pattern.

FIG. 61 is a view for explaining pattern recognition accuracy according to Epoch.

FIG. 62 is a view for explaining a light adaptation test result when a weak light stimulation is applied.

FIG. 63 is a view for explaining a light adaptation test result when a strong light stimulation is applied.

FIG. 64 is a view for explaining a light adaptation test result when the strong light stimulation and electrical stimulation are applied.

FIG. 65 is a view showing an OR logic operation according to a change in an optical signal and a change in an electrical signal.

FIG. 66 is a view showing an AND logic operation according to a change in an optical signal and a change in an electrical signal.

FIG. 67 is a view for explaining multi-state characteristics of the Fe FET device according to the experimental example of the present invention.

FIG. 68 is a view showing a current value when conditional stimulation is applied.

FIG. 69 is a view showing a current value when unconditional stimulation is applied.

FIG. 70 is a view showing a current value when the conditional stimulation and the unconditional stimulation are simultaneously applied.

FIG. 71 is a view showing a current value when only the conditional stimulation is applied after training.

DETAILED DESCRIPTION OF THE INVENTION

Hereinafter, preferred embodiments of the present invention will be described in detail with reference to the accompanying drawings. However, the present invention may be embodied in different forms and should not be construed as limited to the embodiments set forth herein. Rather, the embodiments are provided so that this disclosure will be thorough and complete, and will fully convey the scope of the present invention to those skilled in the art.

In the present specification, it will be understood that when an element is referred to as being "on" another element, it can be formed directly on the other element or intervening elements may be present. In the drawings, the thicknesses of layers and regions are exaggerated for clarity.

In addition, it will be also understood that although the terms first, second, third, etc. may be used herein to describe various elements, these elements should not be limited by these terms. These terms are only used to distinguish one element from another element. Thus, a first element in some embodiments may be termed a second element in other embodiments without departing from the teachings of the present invention. Embodiments explained and illustrated herein include their complementary counterparts. As used herein, the term "and/or" includes any and all combinations of one or more of the associated listed elements.

The singular expression also includes the plural meaning as long as it does not differently mean in the context. In addition, the terms "comprise", "have" etc., of the description are used to indicate that there are features, numbers, steps, elements, or combination thereof, and they should not exclude the possibilities of combination or addition of one or more features, numbers, operations, elements, or a combination thereof. Furthermore, it will be understood that when an element is referred to as being "connected" or "coupled" to another element, it may be directly connected or coupled to the other element or intervening elements may be present.

In addition, when detailed descriptions of related known functions or constitutions are considered to unnecessarily cloud the gist of the present invention in describing the present invention below, the detailed descriptions will not be included.

**Heterojunction Structure Device And Method for Manufacturing The Same**

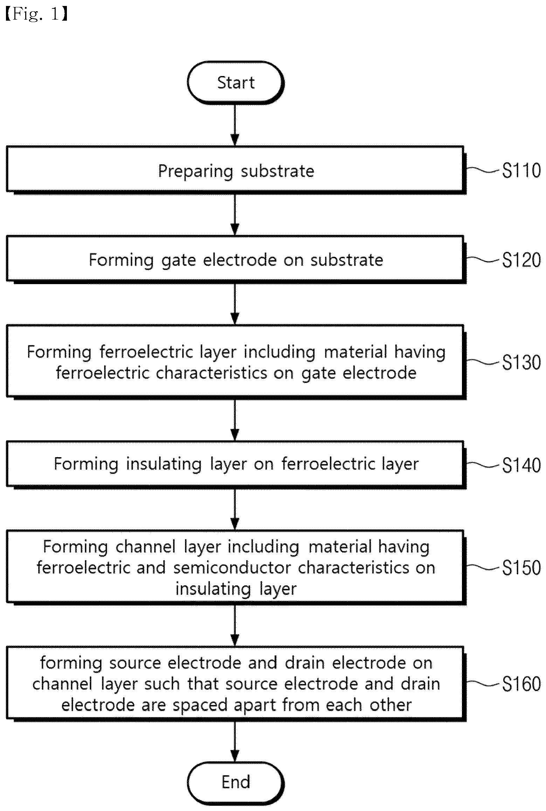

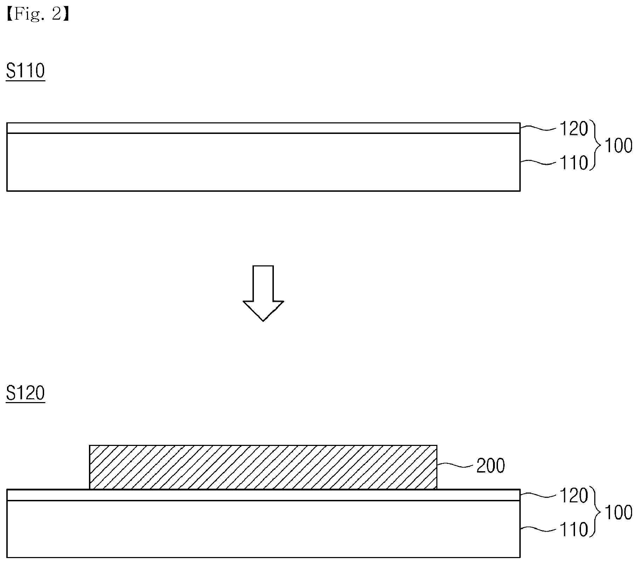

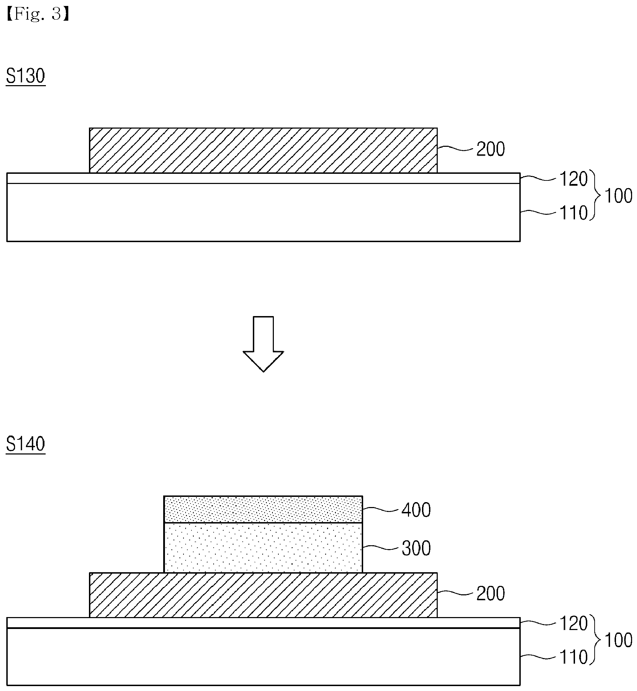

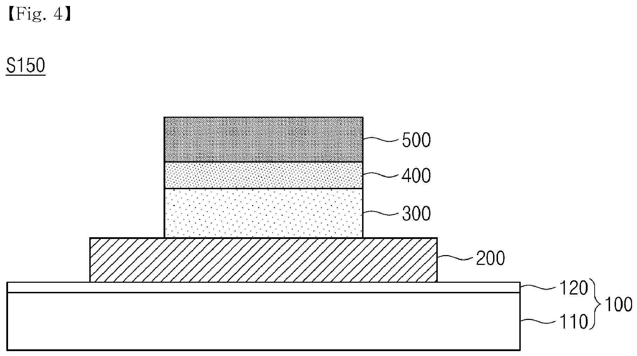

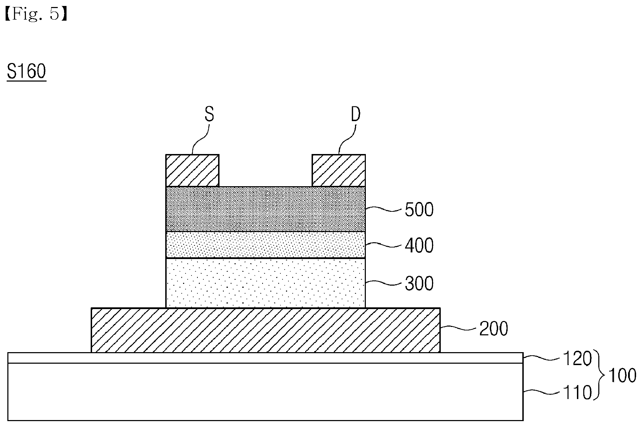

FIG. 1 is a flowchart for explaining a method for manufacturing a heterojunction structure device according to an embodiment of the present invention, FIG. 2 is a schematic view for explaining step S110 and step S120 in the method for manufacturing a heterojunction structure device according to the embodiment of the present invention, FIG. 3 is a schematic view for explaining step S130 and step S140 in the method for manufacturing a heterojunction structure device according to the embodiment of the present invention, FIG. 4 is a schematic view for explaining step S150 in the method for manufacturing a heterojunction structure device according to the embodiment of the present invention, and FIG. 5 is a schematic view for explaining step S160 in the method for manufacturing a heterojunction structure device according to the embodiment of the present invention.

Referring to FIGS. 1 and 2, a substrate 100 may be prepared (S110). According to one embodiment, the substrate 100 may be a silicon semiconductor substrate. More specifically, the substrate 100 may be a substrate in which a silicon oxide ($SiO_2$) layer 120 is formed on a silicon (Si) substrate 110. Alternatively, according to another embodiment, the substrate 100 may be a compound semiconductor substrate. Alternatively, according to still another embodiment, the substrate 100 may be a glass substrate. Alternatively, according to still another embodiment, the substrate 100 may be a plastic substrate. The type of the substrate 100 is not limited.

A gate electrode 200 may be formed on the substrate 100 (S120). According to one embodiment, the gate electrode 200 may include metal. For example, the gate electrode 200 may include gold (Au). According to one embodiment, the gate electrode 200 may be formed by an E-beam lithography method and an E-beam deposition method. In addition, according to one embodiment, the gate electrode 200 may be formed to a thickness of 60 nm. The above-described method, material, and thickness of the gate electrode 200 are merely examples, and the method, material, and thickness of the gate electrode 200 are not limited thereto.

Referring to FIGS. 1 and 3, a ferroelectric layer 300 may be formed on the gate electrode 200 (S130). According to one embodiment, the ferroelectric layer 300 is a material having ferroelectric characteristics, and may include any one of hafnium zirconium oxide (HZO), arsenic (As), antimony (Sb), bismuth (Bi), tellurium (Te), d1T-MoS$_2$, t-MoS$_2$, WS$_2$, WSe$_2$, WTe$_2$, BiN, SbN, BiP, GaN, GaSe, SiC, BN, AIN, ZnO, GeS, GeSe, SnS, SnSe, SiTE, GeTe, SnTE, PbTe, CrN, CrB$_2$,

$CrBr_3$, $CrI_3$, GaTeCl, $AgBiP_2Se_6$, $CuCrP_2S_6$, $CuCrP_2Se_6$, $CuVP_2S_6$, $CuVP_2Se_6$, $CuInP_2Se_6$, $CuInP_2S_6$(CIPS), $Sc_2CO_2$, $Bi_2O_2Se$, $Bi_2O_2Te$, $Bi_2O_2s$, $Ba_2PbCl_4$, graphanol, hydroxyl-functionalized graphene, halogen-decorated phosphorene, g-$C_6N_8H$, and Bi-$CH_3OH$.

According to one embodiment, the ferroelectric layer 300 may be formed by a method for dry-transferring a ferroelectric material, which is mechanically exfoliated from a bulk, onto the gate electrode 200. The method for forming the ferroelectric layer 300 is not limited.

An insulating layer 400 may be formed on the ferroelectric layer 300. According to one embodiment, the insulating layer 400 may include hexagonal boron nitride (h-BN). In this case, the insulating layer 400 may be formed by dry-transferring hexagonal boron nitride (h-BN) mechanically exfoliated from bulk onto the ferroelectric layer 300. Alternatively, according to another embodiment, the insulating layer 400 may include any one of aluminum oxide ($Al_2O_3$), silicon oxide ($SiO_3$), and hafnium oxide ($HfO_2$).

The insulating layer 400 is for reducing a gate leakage current between the ferroelectric layer 300 and a channel layer 500 to be described later, and when the insulating layer 400 is omitted, a device degradation problem due to the gate leakage current may occur.

Referring to FIGS. 1 and 4, the channel layer 500 may be formed on the insulating layer 400 (S150). According to one embodiment, the channel layer 500 may include a material having ferroelectric and semiconductor characteristics. For example, the channel layer 500 may include any one of alpha-indium selenide ($\alpha$-$In_2Se_3$), 1T-$MoS_2$, MoSSe, MoTe, SnS, SnSe, SnTe, GeS, GeSe, and GeTe.

According to one embodiment, the channel layer 500 may be formed by a method for dry-transferring a ferroelectric material, which is mechanically exfoliated from the bulk, onto the insulating layer 400. The method for forming the channel layer 500 is not limited.

Referring to FIGS. 1 and 5, a source electrode S and a drain electrode D may be formed on the channel layer 500 while being spaced apart from each other (S160). According to one embodiment, the source electrode S may include titanium (Ti) and gold (Au). More specifically, the source electrode S may have a structure in which gold (Au) having a thickness of 60 nm is stacked on titanium (Ti) having a thickness of 10 nm. Moreover, according to one embodiment, the drain electrode D may include titanium (Ti) and gold (Au). More specifically, the drain electrode D may have a structure in which gold (Au) having a thickness of 60 nm is stacked on titanium (Ti) having a thickness of 10 nm. According to one embodiment, the source electrode S and the drain electrode D may be formed by the E-beam deposition method. The material and method for forming the source electrode S and the drain electrode D are not limited.

That is, the heterojunction structure device according to the embodiment of the present invention may be implemented as a ferroelectric field effect transistor (Fe FET) including the gate electrode 200 disposed on the substrate 100, the ferroelectric layer 300 disposed on the gate electrode, the insulating layer 400 disposed on the ferroelectric layer, the channel layer 500 disposed on the insulating layer 400, and the source electrode S and the drain electrode D disposed on the channel layer 500 while being spaced apart from each other.

In addition, the present invention may be easily applied to an artificial visual system by performing all sensing, processing, and memorizing of external signals (optical signals and electrical signals) in a single device of the ferroelectric field effect transistor.

To this end, the present invention may be configured such that the ferroelectric layer 300 includes a material having out-of-plane (OOP) polarization characteristics, and the channel layer 500 includes a material having both the out-of-plane (OOP) polarization characteristics and in-plane (IP) polarization characteristics. More specifically, the present invention may be configured such that the ferroelectric layer 300 includes $CuInP_2S_6$ (CIPS), and the channel layer 500 includes alpha-indium selenide ($\alpha$-$In_2Se_3$). In addition, the present invention may be configured such that the insulating layer 400 includes hexagonal boron nitride (h-BN) in order to maintain an influence of electrical potential energy, which is generated by a polarization phenomenon occurring in the ferroelectric layer 300, on a polarization shape of the channel layer 500.

In describing the present invention, the "polarization" may mean a phenomenon in which positions of negative charges and positive charges are separated in an electric field to have a dipole moment. In addition, the "in-plane polarization" may mean a phenomenon in which positions of negative charges and positive charges are separated along a direction parallel to a linear direction from the source electrode S to the drain electrode D to have a dipole moment. In addition, the "out-of-plane polarization" may mean a phenomenon in which positions of negative charges and positive charges are separated along a direction perpendicular to a linear direction from the source electrode S to the drain electrode D to have a dipole moment.

In the ferroelectric field effect transistor having the above-described structure (bottom electrode/CIPS/h-BN/$\alpha$-$In_2Se_3$), polarization of the channel layer 500 may be controlled by light irradiated to the channel layer 500, and polarization of the ferroelectric layer 300 may be controlled by a voltage applied to the gate electrode 200. Accordingly, the ferroelectric field effect transistor may perform all of detecting, processing, and memorizing of external signals (optical signals and electrical signals) in a single device. Therefore, the ferroelectric field effect transistor may be easily applied to an artificial visual system.

In addition, the ferroelectric field effect transistor may detect light in a wide wavelength range (for example, 405 nm to 850 nm) and light having very low intensity (0.03 mW/cm$^3$) due to intrinsic polarization characteristics (bidirectional polarization characteristics in which in-plane polarization and out-of-plane polarization are connected to each other) of the channel layer ($\alpha$-In$_2$Se$_3$).

In addition, the ferroelectric field effect transistor may implement paired pulse facilitation (PPF), which is electrical characteristics that an artificial synapse device necessarily have, and characteristics of transition from short term memory (STM) to long term memory (LTM), and may perform logic operations such as pattern recognition, light adaptation training, Pavlov's training, and the like. The characteristics of the ferroelectric field effect transistors will be described in more detail through experimental examples to be described later.

Unlike the above description, in a ferroelectric field effect transistor having a $\alpha$-In$_2$Se$_3$/h-BN/CIPS/upper electrode structure, since the channel layer is covered by the upper electrode, light irradiation of the channel layer may not be efficiently performed. In addition, a lower electrode/CIPS structure may form a Van der Waals metal contact, whereas the CIPS/upper electrode structure may form a thermally evaporated metal contact. In the case of thermally evaporated metal contact, various defects such as interstitial defects, void defects, and anti-site defects may be more easily formed compared to the Van der Waals metal contact. That is, in the case of the CIPS/upper electrode structure, various physical and chemical defects are more frequently formed in the CIPS and the electrode compared to the lower electrode/CIPS structure.

Hereinabove, the heterojunction structure device and the method for manufacturing the same according to the embodiment of the present invention have been described. Hereinafter, various application examples of a heterojunction structure (CIPS/h-BN/$\alpha$-In$_2$Se$_3$) according to the embodiment of the present invention will be described.

According to one embodiment, the heterojunction structure (CIPS/h-BN/$\alpha$-In$_2$Se$_3$) according to the embodiment of the present invention may be used as a semiconductor layer of a solar cell. More specifically, the heterojunction structure (CIPS/h-BN/$\alpha$-In$_2$Se$_3$) may be applied to a solar cell that converts light energy into electrical energy by using a photovoltaic effect.

Alternatively, according to another embodiment, the heterojunction structure (CIPS/h-BN/$\alpha$-In$_2$Se$_3$) may be applied to a gas sensor. More specifically, the heterojunction structure (CIPS/h-BN/$\alpha$-In$_2$Se$_3$) has spontaneous polarization with respect to an electric force, and thus may adsorb or release gas molecules (e.g., NH$_3$ gas molecules or NO$_2$ gas molecules) along a polarization direction of a surface of the ferroelectric material.

Alternatively, according to still another embodiment, the heterojunction structure (CIPS/h-BN/$\alpha$-In$_2$Se$_3$) may be applied to a piezoelectric sensor. More specifically, since the ferroelectric has piezoelectric characteristics, the ferroelectric may be applied to a piezoelectric sensor using a phenomenon in which dielectric polarization occurs in the heterojunction structure (CIPS/h-BN/$\alpha$-In$_2$Se$_3$) by physical deformation applied to the heterojunction structure (CIPS/h-BN/$\alpha$-In$_2$Se$_3$).

Hereinabove, various application examples of the heterojunction structure according to the embodiment of the present invention have been described. Hereinafter, various modification examples of the heterojunction structure device according to the embodiment of the present invention will be described.

### First Modification Example: CIPS/h-BN/$\alpha$-In$_2$Se$_3$ + Mxene Artificial Synapse Device

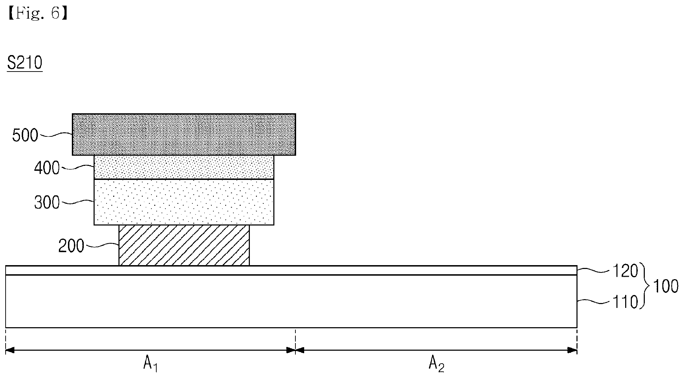

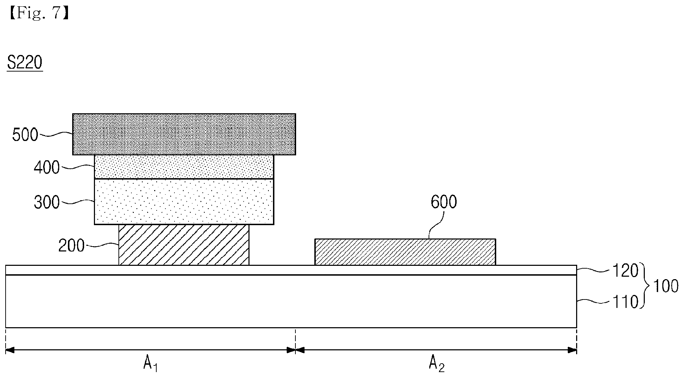

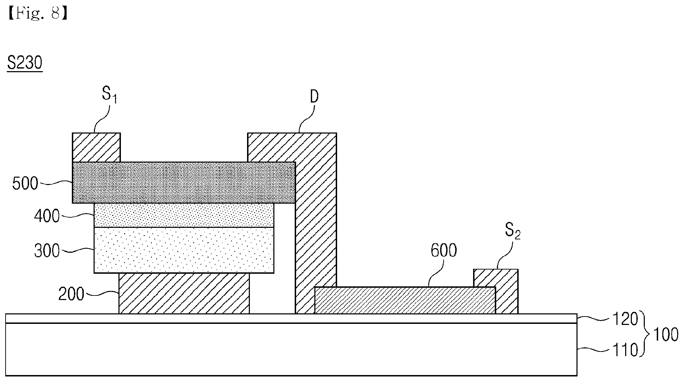

FIG. 6 is a schematic view for explaining step S210 in a method for manufacturing an artificial synapse device according to a first modification example of the present invention, FIG. 7 is a schematic view for explaining step S220 in the method for manufacturing an artificial synapse device according to the first modification example of the present invention, and FIG. 8 is a schematic view for explaining step S230 in the method for manufacturing an artificial synapse device according to the first modification example of the present invention.

Referring to FIG. 6, a gate electrode 200, a ferroelectric layer 300, an insulating layer 400, and a first channel layer 500 may be sequentially formed on a first region A$_1$ of a substrate 100 that includes the first region A$_1$ and a second region A$_2$ different from the first region A$_1$ (S210).

According to one embodiment, the method for forming the gate electrode 200, the ferroelectric layer 300, the insulating layer 400, and the first channel layer 500 may be the same as the method for forming the gate electrode 200, the ferroelectric layer 300, the insulating layer 400, and the channel layer 500 of the heterojunction structure device described with reference to FIGS. 1 to 4.

Referring to FIG. 7, a second channel layer 600 may be formed on the second region A$_2$ of the substrate 100 (S220). According to one embodiment, the second channel layer 600 may include Mxene.

Referring to FIG. 8, a first source electrode S$_1$, a drain electrode D, and a second source electrode S$_2$ may be formed on the first channel layer 500 and the second channel layer 600 (S230). More specifically, the first source electrode S$_1$ may be formed on one side of an upper surface of the first channel layer 500 and the drain electrode D may be formed on the other side thereof. In addition, the drain electrode D may be formed on one side of an upper surface of the second channel layer 600 and the second source electrode S$_2$ may be formed on the other side thereof. In addition, the drain electrode D may be formed such that the first channel layer 500 and the second channel layer 600 share each other. That is, the drain electrode D may be formed to make contact with the other end of the upper surface of the first channel layer 500 and to make contact with one side of the upper surface of the second channel layer 600.

The first channel layer 500, that is, $\alpha$-In$_2$Se$_3$, may be responsible for potentiation in the artificial synapse device, and the second channel layer 600, that is, Mxene, may be responsible for depression in the artificial synapse device. In addition, in the artificial synapse device having the above-described structure (CIPS/h-BN/$\alpha$-In$_2$Se$_3$ + Mxene), both the potentiation of the first channel layer 500 and the depression of the second channel layer 600 may occur by an optical signal. That is, only the single signal (optical signal) may cause the potentiation and the depression. Accordingly, the burden and complexity of peripheral circuits may be reduced, and the processing speed of the system may also be improved.

In contrast, in the case of the artificial synapse device having the structure (CIPS/h-BN/$\alpha$-In$_2$Se$_3$) described with reference to FIGS. 1 to 5, potentiation may occur by the optical signal and depression may occur by the electrical signal due to a unidirectional optical reaction. As described above, when two signals (the optical signal and the electrical signal) are combined and used, the burden and complexity of peripheral circuits may be increased, and the processing speed of the system may be limited.

## Second Modification Example: CIPS/h-BN/$\alpha$-In$_2$Se$_3$ + Mxene + Oxide Layer Artificial Synapse Device

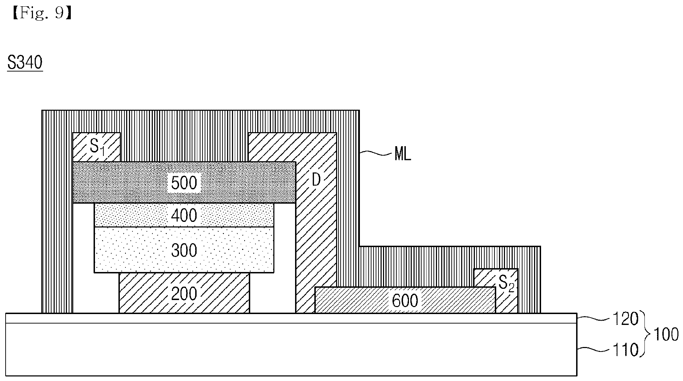

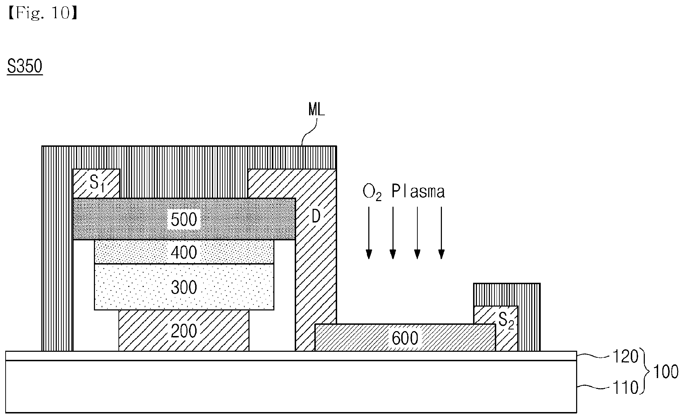

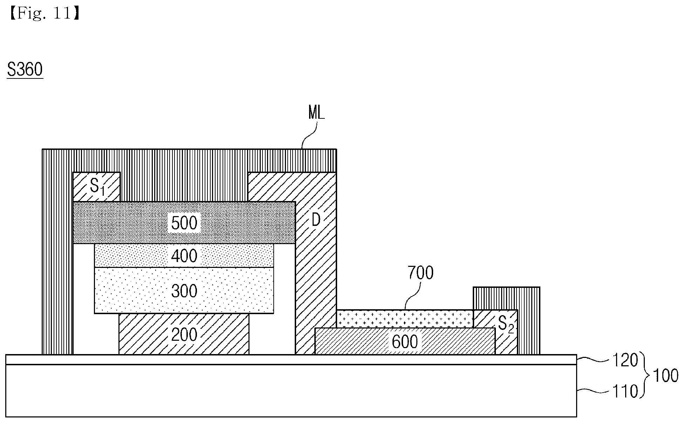

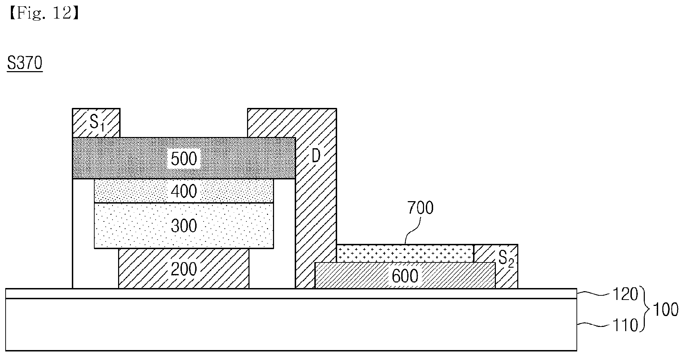

FIG. 9 is a schematic view for explaining step S340 in a method for manufacturing an artificial synapse device according to a second modification example of the present invention, FIG. 10 is a schematic view for explaining step S350 in the method for manufacturing an artificial synapse device according to the second modification example of the present invention, FIG. 11 is a schematic view for explaining step S360 in the method for manufacturing an artificial synapse device according to the second modification example of the present invention, FIG. 12 is a schematic view for explaining step S370 in a method for manufacturing an artificial synapse device according to a second modification example of the present invention.

A method for manufacturing an artificial synapse device according to a second modification example of the present invention may include: a step S310 of sequentially forming a gate electrode 200, a ferroelectric layer 300, an insulating layer 400, and a first channel layer 500 on a first region $A_1$ of a substrate 100, a step S320 of forming a second channel layer 600 on a second region $A_2$ of the substrate 100, a step S330 of forming a first source electrode $S_1$, a drain electrode D, and a second source electrode $S_2$ on the second channel layer 600 of the first channel layer $A_1$ and the second region $A_2$, a step S340 of forming a mask layer ML, a step S350 of etching the mask layer ML, a step S360 of forming an oxide layer 700, and a step S370 of removing the mask layer ML.

Steps S310 to S330 included in the method for manufacturing the artificial synapse device according to the second modification example may be the same as steps S210 to S230 included in the method for manufacturing the artificial synapse device according to the first modification example described with reference to FIGS. 6 to 8. Accordingly, the detailed description thereof will be omitted.

Referring to FIG. 9, the mask layer ML may be formed on the substrate 100 to cover the first source electrode Si, the drain electrode D, the second source electrode $S_2$, the first channel layer 500, and the second channel layer 600. According to one embodiment, the mask layer ML may include polymer. For example, the polymer may include polymethyl methacrylate (PMMA).

Referring to FIG. 10, the mask layer ML disposed between the second source electrode $S_2$ and the drain electrode D and overlapping the second channel layer 600 may be etched. According to one embodiment, the etching of the mask layer ML may be performed through oxygen (O$_2$) plasma treatment and E-beam lithography. Accordingly, in the upper surface of the second channel layer 600, an upper surface between the second source electrode $S_2$ and the drain electrode D may be exposed to the outside.

Referring to FIGS. 11 and 12, after the oxide layer 700 is formed on the exposed upper surface of the second channel layer 600 (S360), the mask layer ML remaining on the substrate 100 may be removed (S370). According to one embodiment, the oxide layer 700 may include metal oxide. For example, the oxide layer 700 may include titanium oxide (TiO$_2$).

In the case of Mxene included in the second channel layer 600, oxidation easily occurs due to contact with air, the oxidized region acts as a charge trap site, and the charge trap site acts as a scattering center under light illumination, thereby reducing electrical conductivity. That is, when the second channel layer 600 is exposed to the outside, oxidation may occur due to contact with air, and thus electrical conductivity may be reduced. However, in the case of the artificial synapse device according to the second modified example, the oxide layer 700 is formed on the exposed upper surface of the second channel layer 600, so that it is possible to easily solve the conductivity reduction problem generated as the second channel layer 600 makes contact with the air.

**Third Modification Example: Gate Split-Type Ferroelectric Field Effect Transistor (Split Gate Fe FET)**

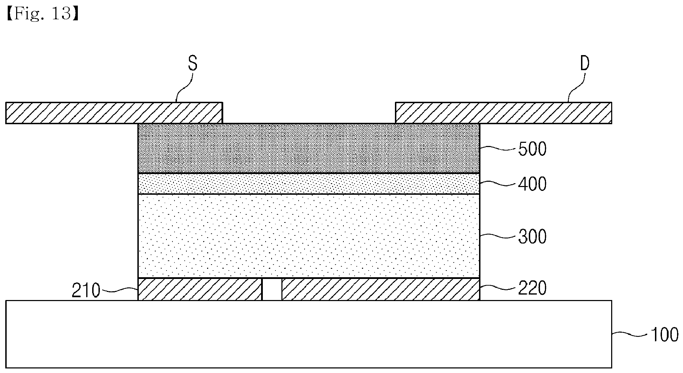

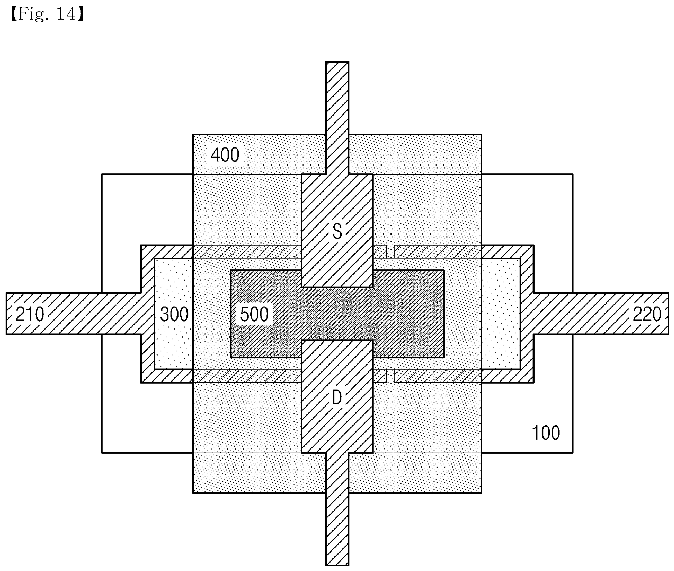

FIG. 13 is a schematic sectional view of a ferroelectric field effect transistor according to a third modification example of the present invention, and FIG. 14 is a schematic plan view of the ferroelectric field effect transistor according to the third modification example of the present invention.

Referring to FIGS. 13 and 14, the ferroelectric field effect transistor according to the third modified example may include: a substrate 100; a first gate electrode 210 and a second gate electrode 220 disposed on the substrate 100 while being spaced apart from each other; a ferroelectric layer 300 disposed on the first gate electrode 210 and the second gate electrode 220; an insulating layer 400 disposed on the ferroelectric layer 300; a channel layer 500 disposed on the insulating layer 400; and a source electrode S and a drain electrode D disposed on the channel layer 500 while being spaced apart from each other.

According to one embodiment, the substrate 100, the first and second gate electrodes 210 and 220, the ferroelectric layer 300, the insulating layer 400, the channel layer 500, the source electrode S, and the drain electrode D included in the ferroelectric field effect transistor according to the third modification may be the same as the substrate 100, the gate electrode 200, the ferroelectric layer 300, the insulating layer 400, the channel layer 500, the source electrode S, and the drain electrode D included in the heterojunction structure element described with reference to FIGS. 1 to 5.

In the ferroelectric field effect transistor according to the third modification example, areas of the first gate electrode 210 and the second gate electrode 220 may be controlled to form a flexible change in a memory window. In addition, a subthreshold swing may be reduced by using both the first gate electrode 210 and the second gate electrode 220 in a write operation, and the memory window may be improved by using only one gate electrode of the first gate electrode 210 and the second gate electrode 220 in a read operation. Accordingly, it is possible to implement a spiking neural network (SNN) in which artificial synapse and spiking neuron are combined.

Hereinabove, various modification examples of the heterojunction structure device according to the embodiment of the present invention have been described. Hereinafter, specific experimental examples and characteristic evaluation results of the heterojunction structure device according to the embodiment of the present invention will be described.

Experimental Example 1: Manufacture And Structural Characteristics of Fe FET Device

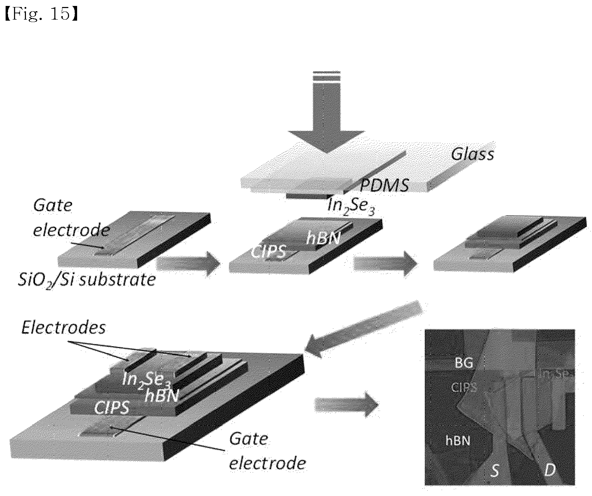

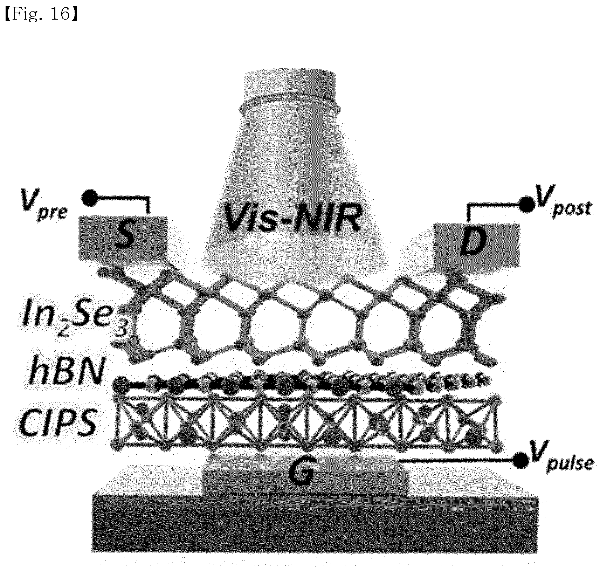

FIG. 15 is a schematic view for explaining a method for manufacturing a Fe FET device according to an experimental example of the present invention, and FIG. 16 is a schematic view for explaining the Fe FET device according to the experimental example of the present invention.

Referring to FIGS. 15 and 16, a gold (Au) electrode having a thickness of 60 nm was deposited as a gate electrode on a $SiO_2$/Si substrate by E-beam lithography and E-beam deposition. Thereafter, a plurality of layers of $CuInP_2S_6$ (CPS), h-BN, and $\alpha$-$In_2Se_3$ were secured by a physical exfoliation method, and were sequentially transferred onto the gate electrode by a dry transfer method to form a heterojunction structure in the form of CIPS/h-BN/$\alpha$-$In_2Se_3$ (ferroelectric layer/insulating layer/channel layer). Finally, a source electrode and a drain electrode were deposited on $\alpha$-$In_2Se_3$ (channel layer) while being spaced apart from each other. Specifically, both the source electrode and the drain electrode used a structure in which gold (Au) having a thickness of 60 nm is stacked on titanium (Ti) having a thickness of 10 nm.

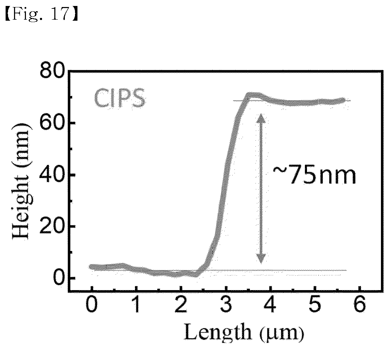

FIG. 17 is a view for explaining an AFM analysis result of a ferroelectric layer of the Fe FET device according to the experimental example of the present invention.

Referring to FIG. 17, it shows an atomic force microscopy (AFM) analysis result of a ferroelectric layer (CIPS) of the Fe FET device according to the experimental example and a thickness of the ferroelectric layer measured through the AFM analysis result. As can be seen from FIG. 17, the ferroelectric layer (CIPS) has a thickness of about 75 nm.

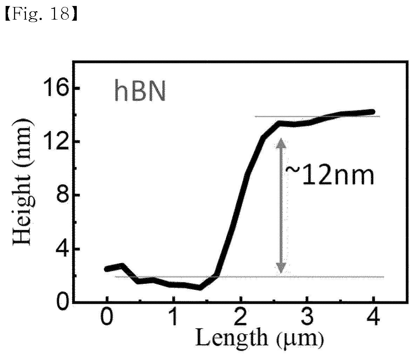

FIG. 18 is a view for explaining an AFM analysis result of an insulating layer of the Fe FET device according to the experimental example of the present invention.

Referring to FIG. 18, it shows an atomic force microscopy (AFM) analysis result of an insulating layer (hBN) of the Fe FET device according to the experimental example and a thickness of the ferroelectric layer measured through the AFM analysis result. As can be seen from FIG. 18, the insulating layer (hBN) has a thickness of about 12 nm.

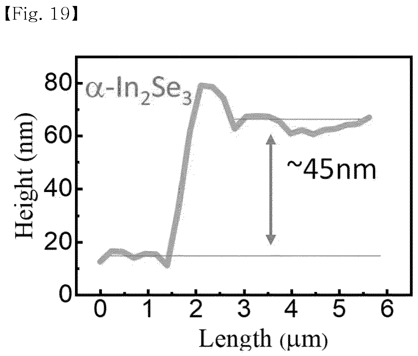

FIG. 19 is a view for explaining an AFM analysis result of a channel layer of the Fe FET device according to the experimental example of the present invention.

Referring to FIG. 19, it shows an atomic force microscopy (AFM) analysis result of a channel layer ($\alpha$-$In_2Se_3$) of the Fe FET device according to the experimental example and a thickness of the channel layer measured through the AFM analysis result. As can be seen from FIG. 19, the channel layer ($\alpha$-$In_2Se_3$) has a thickness of about 45 nm.

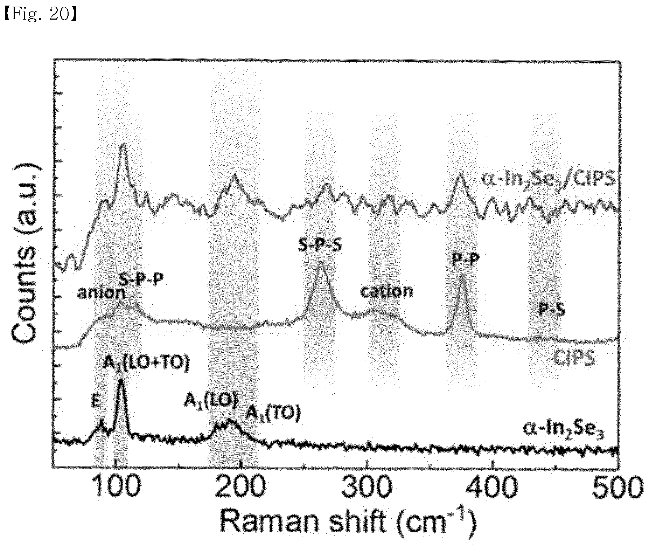

FIG. 20 is a view for explaining a Raman analysis result of a heterojunction structure of the Fe FET device according to the experimental example of the present invention.

Referring to FIG. 20, it shows a Raman spectra measurement result of each of the ferroelectric layer (CIPS), the channel layer ($\alpha$-$In_2Se_3$), and a CIPS/$\alpha$-$In_2Se_3$ junction structure of the Fe FET device according to the experimental example. Specifically, a black line indicates a measurement result for the channel layer ($\alpha$-$In_2Se_3$), a red line indicates a measurement result for the ferroelectric layer (CIPS), and a blue line indicates a measurement result for the CIPS/$\alpha$-In$_2$Se$_3$ junction structure. As can be seen from FIG. 20, the general $\alpha$-In$_2$Se$_3$ and CIPS are used through the Raman peak.

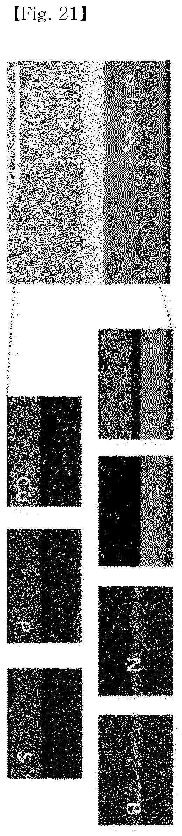

FIG. 21 is a view for explaining a TEM image and an EDS mapping image for the heterojunction structure of the Fe FET device according to the experimental example of the present invention.

Referring to FIG. 21, it shows a transmission electron microscope (TEM) image and an energy dispersive X-ray spectroscopy (EDS) mapping image of a heterojunction structure (CIPS/h-BN/$\alpha$-In$_2$Se$_3$) of the Fe FET device according to the experimental example.

As can be seen from FIG. 21, CIPS and $\alpha$-In$_2$Se$_3$ are formed to be clearly distinguished by h-BN, and the composition of each layer (ferroelectric layer, insulating layer, and channel layer) is also clearly distinguished.

Experimental Example 2: Operation of Fe FET Device

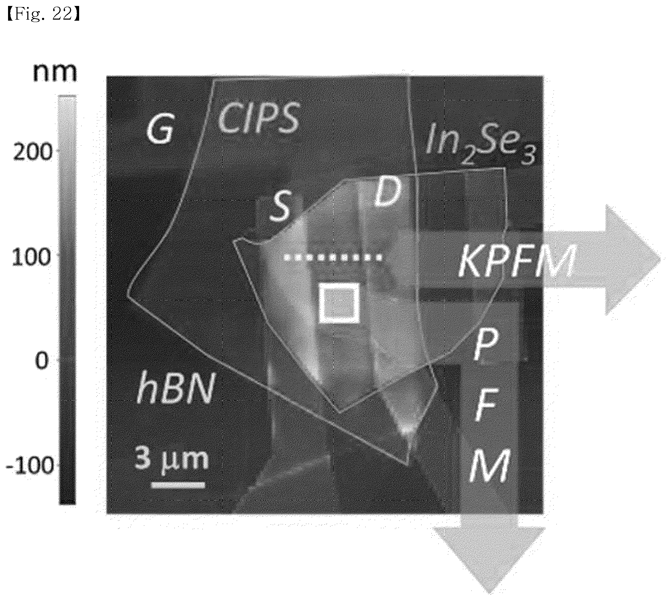

FIG. 22 is a view showing a position in which AFM scanning is used to confirm an operation of the Fe FET device according to the experimental example of the present invention.

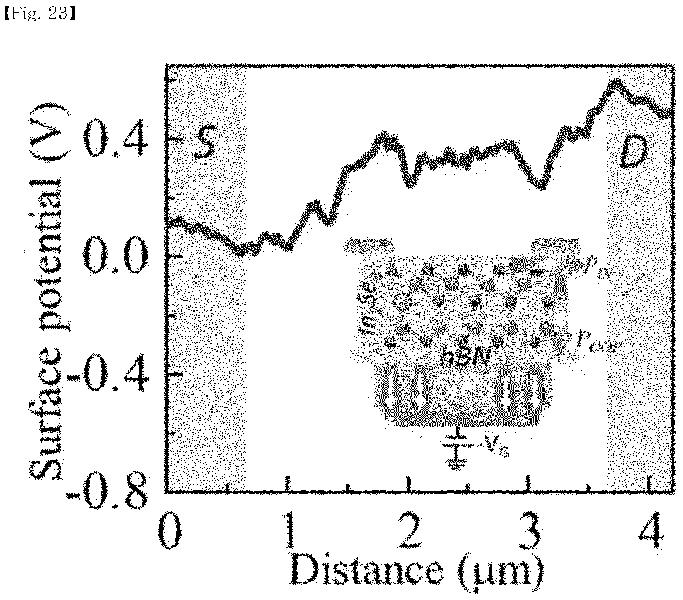

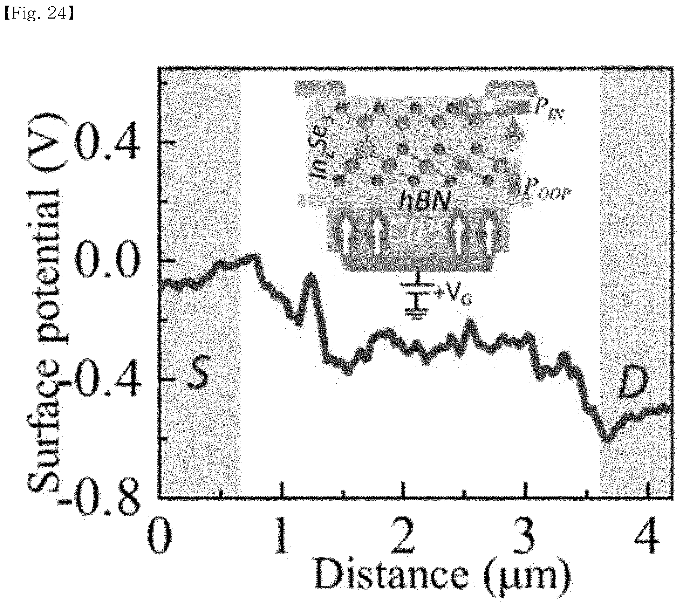

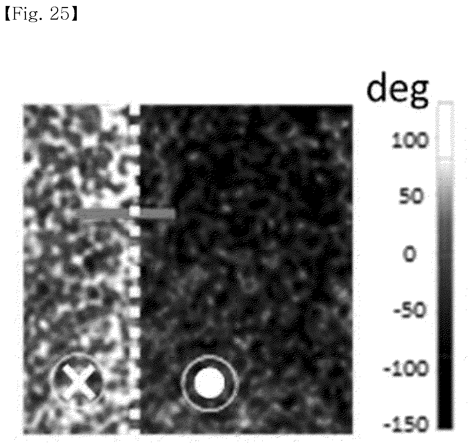

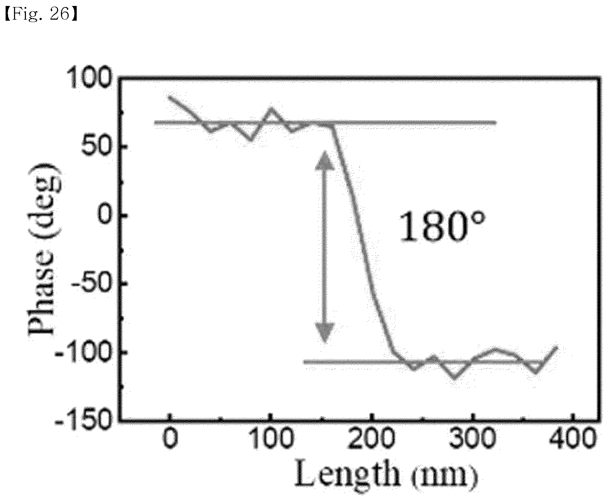

Referring to FIG. 22, it shows a position in which atomic force microscopy (AFM) scanning is used to confirm an operation of the Fe FET device according to the experimental example. Specifically, a white dotted line region (channel layer region) indicated between the source electrode S and the drain electrode D represents a measurement region using Kelvin probe force microscopy (KPFM) in FIGS. 23 and 24 to be described later, and a white box region (channel layer region) represents a measurement region using piezoresponse force microscopy (PFM) in FIGS. 25 and 26 to be described later.

FIG. 23 is a view showing a surface potential measured in the channel layer between a source electrode and a drain electrode when a negative voltage is applied to a gate electrode, and FIG. 24 is a view showing a surface potential measured in the channel layer between the source electrode and the drain electrode when a positive voltage is applied to the gate electrode.

Referring to FIGS. 23 and 24, as described with reference to FIG. 22, a surface potential (V) is measured and shown using Kelvin probe force microscopy (KPFM) with respect to the white dotted line region. More specifically, FIG. 23 shows a surface potential measured when a negative voltage is applied to the gate electrode, and FIG. 24 shows a surface potential measured when a positive voltage is applied to the gate electrode.

As can be seen from FIG. 23 and FIG. 24, a slope of the surface potential (increasing from the source electrode to the drain electrode) when the negative voltage is applied to the gate electrode and a slope of the surface potential (decreasing from the source electrode to the drain electrode) when the positive voltage is applied appear to have opposite characteristics. That is, it can be seen that as the voltage is applied to the gate electrode, in-plane (IP) polarization occurs in the channel layer ($\alpha$-In$_2$Se$_3$), and positions of the negative and positive charges of the dipole moment are reversely generated according to polarity (positive voltage or negative voltage) of the applied voltage.

In addition, it can be seen that out-of-plane (OOP) polarization occurs in the ferroelectric layer (CIPS) by the voltage applied to the gate electrode, and thus the out-of-plane (OOP) polarization also occurs in the channel layer ($\alpha$-In$_2$Se$_3$), and the in-plane (IP) polarization also occurs continuously in the channel layer ($\alpha$-In$_2$Se$_3$) due to the out-of-plane (OOP) polarization in the channel layer ($\alpha$-In$_2$Se$_3$).

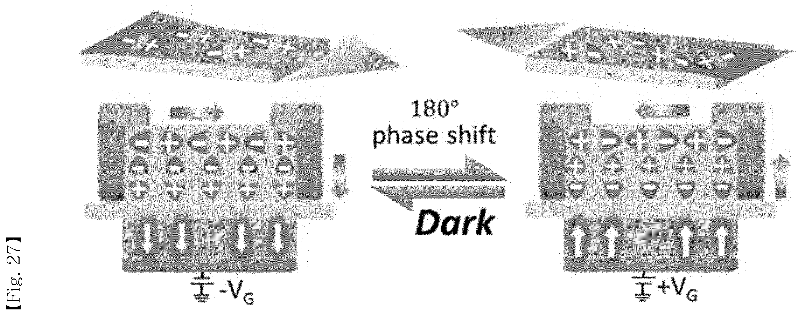

FIG. 25 is a view showing a PFM phase image under a dark condition, FIG. 26 is a view showing a PFM phase value measured when voltages having opposite polarities are applied to the gate electrode under the dark condition, and FIG. 27 is a view showing a schematic view of dipole polarization under the dark condition.

Referring to FIGS. 25 to 27, as described with reference to FIG. 22, a piezoresponse force microscopy (PFM) phase value was measured on a white box region under a dark condition (a condition without light irradiation) using PFM. More specifically, FIG. 26 shows PFM phase values measured when a voltage of -10 V is applied to the gate voltage and a voltage of +10 V is applied to the gate electrode, and FIG. 27 shows dipole polarization in the ferroelectric layer (CIPS) and the channel layer ($\alpha$-In$_2$Se$_3$) when a voltage of -10 V is applied to the gate voltage and a voltage of +10 V is applied to the gate electrode.

As can be seen from FIGS. 25 to 27, spontaneous ferroelectric polarization (180° phase difference) occurs when the voltages (+10 V and -10 V) of opposite polarities are applied under the dark condition. Accordingly, it can be seen that the dipole direction due to the in-plane (IP) polarization of the channel layer may be reversely switched (the positions of the negative charges and the positive charges may be switched by 180°) by reversely controlling the polarity of the voltage applied to the gate voltage under the dark condition.

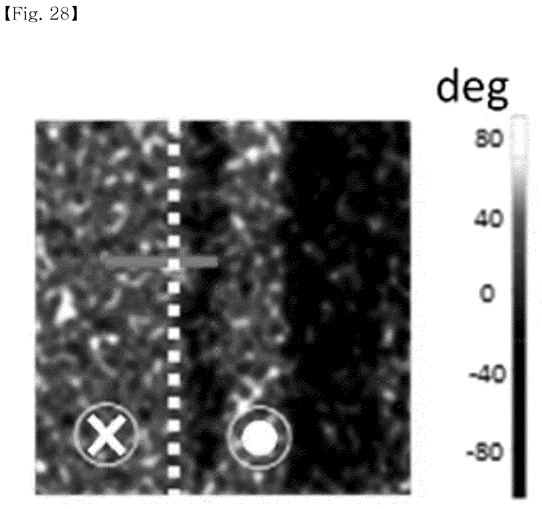

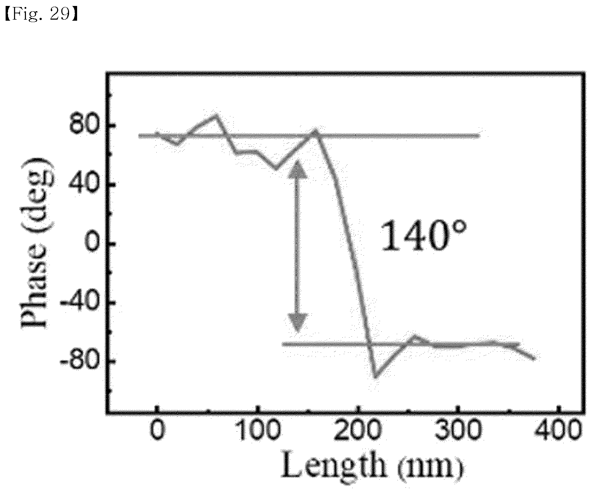

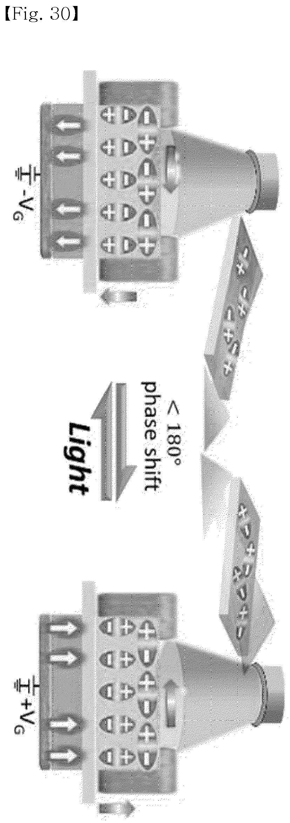

FIG. 28 is a view showing a PFM phase image under a light condition, FIG. 29 is a view showing a PFM phase value measured when voltages having opposite polarities are applied to the gate electrode under the light condition. and FIG. 30 is a view showing a schematic view of dipole polarization under the light condition.

Referring to FIGS. 28 to 30, as described with reference to FIG. 22, a piezoresponse force microscopy (PFM) phase value was measured on a white box region under a light condition (a condition with light irradiation of a wavelength of 655 nm) using PFM. More specifically, FIG. 29 shows PFM phase values measured when a voltage of -10 V is applied to the gate voltage and a voltage of +10 V is applied to the gate electrode, and FIG. 30 shows dipole polarization in the ferroelectric layer (CIPS) and the channel layer ($\alpha$-In$_2$Se$_3$) when a voltage of -10 V is applied to the gate voltage and a voltage of +10 V is applied to the gate electrode.

As can be seen from FIGS. 28 to 30, weak ferroelectric polarization (< 180°) occurs when the voltages (+10 V and -10 V) of opposite polarities are applied under the light condition. Accordingly, it can be seen that the dipole direction due to the in-plane (IP) polarization of the channel layer may not be reversely switched (the positions of the negative charges and the positive charges may be switched by 180°) even if the polarity of the voltage applied to the gate voltage is reversely controlled under the light condition as compared to the dark condition. That is, it can be seen that the in-plane (IP) polarization occurring in the channel layer is more influenced by the light irradiated to the channel layer than the voltage applied to the gate electrode.

Experimental Example 3: Role of Insulation Layer in Fe FET Device

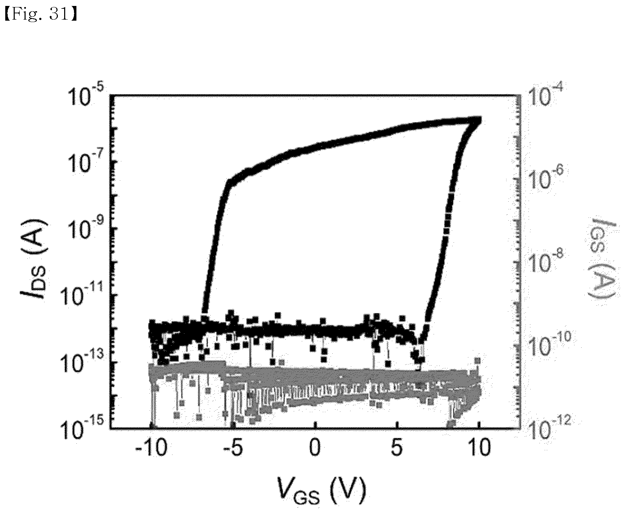

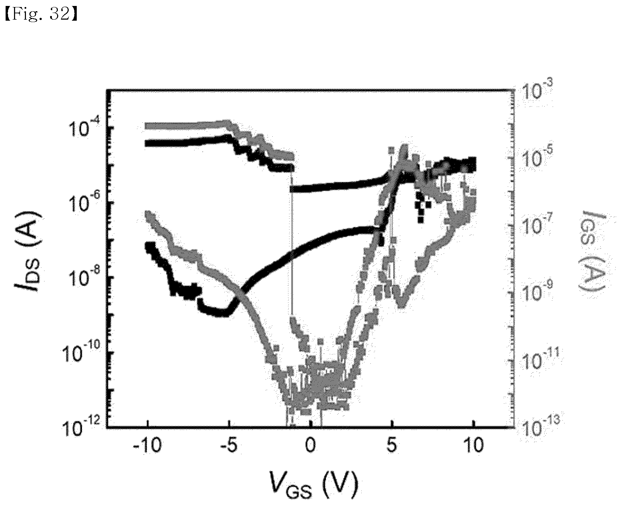

FIG. 31 is a view for explaining voltage-current characteristics of the Fe FET device according to the experimental example of the present invention, and FIG. 32 is a view for explaining voltage-current characteristics of a Fe FET device according to a comparative example of the present invention.

Referring to FIGS. 31 and 32, after the Fe FET device according to the experimental example and the Fe FET device according to the comparative example are prepared, a drain electrode-source electrode current $I_{DS}$ and a gate electrode-source electrode current $I_{GS}$ according to a gate electrode-source electrode voltage $V_{GS}$ are measured and shown for each of the Fe FET device according to the experimental example and the Fe FET device according to the comparative example. More specifically, the Fe FET device according to the comparative example is the same as the Fe FET device according to the experimental example, but a device having a structure in which the ferroelectric layer (CIPS) and the channel layer ($\alpha$-In$_2$Se$_3$) make direct contact with each other by omitting the insulating layer (h-BN) is used.

As can be seen from FIG. 31, in the case of the Fe FET device according to the experimental example, a gate leakage current is rarely generated, whereas, as can be seen from FIG. 32, in the case of the Fe FET device according to the comparative example, the gate leakage current is severely generated. That is, it can be seen that the gate leakage current problem may be significantly solved by disposing the insulating layer (h-BN) between the ferroelectric layer (CIPS) and the channel layer ($\alpha$-In$_2$Se$_3$).

Experimental Example 4: Ferroelectric and Electrical Synaptic Characteristics of Fe FET Device

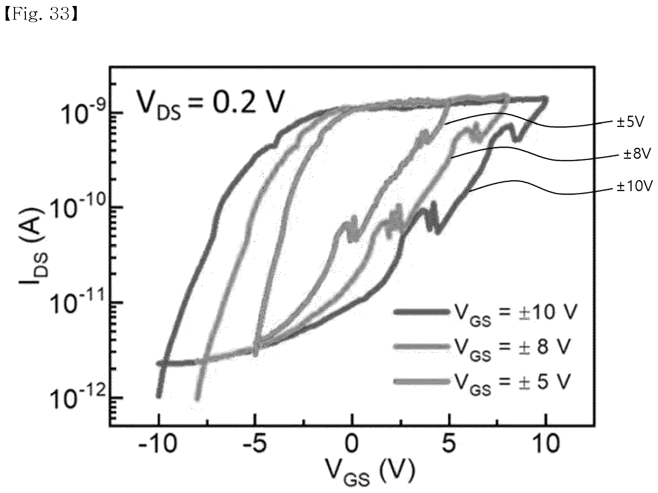

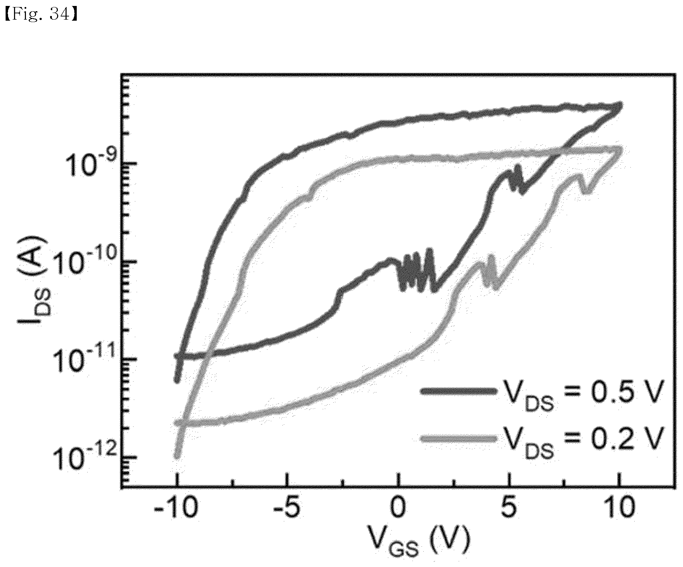

FIG. 33 is a view for explaining a change in transfer characteristics according to a scanning voltage range of the Fe FET device according to the experimental example of the present invention, and FIG. 34 is a view for explaining a change in transfer characteristics according to a change in a read voltage of the Fe FET device according to the experimental example of the present invention.

Referring to FIG. 33, currents $I_{DS}$ (A) according to voltages $V_{GS}$ (V) of the Fe FET device according to the experimental example are measured and shown under various gate voltage $V_{GS}$ conditions in which sweeping is performed on ±5 V, ±8 V, and ±10 V. As can be seen from FIG. 33, an area of transfer characteristic curve $I_D$-$V_G$ increases as the gate voltage condition increases (±5 V -> ±10 V).

Referring to FIG. 34, currents $I_{DS}$ (A) according to voltages $V_{GS}$ (V) of the Fe FET device according to the experimental example are measured and shown under various source-drain voltage $V_{DS}$ conditions of 0.2 V and 0.5 V. As can be seen from FIG. 34, the transfer characteristic curve $I_D$-$V_G$ is also different according to the source-drain voltage $V_{DS}$ condition.

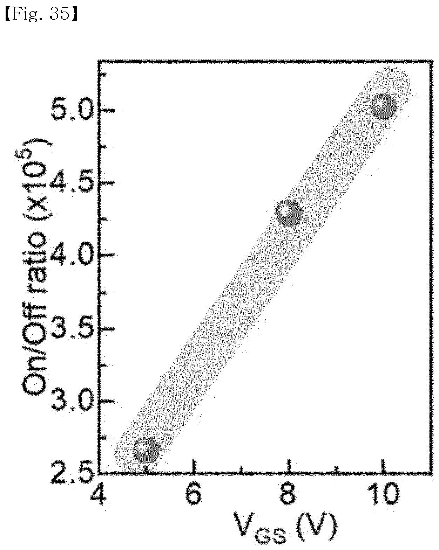

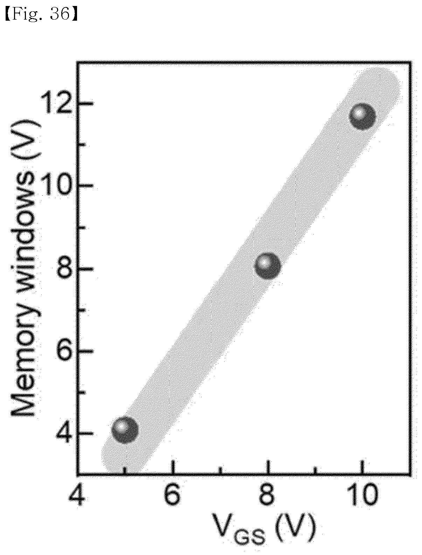

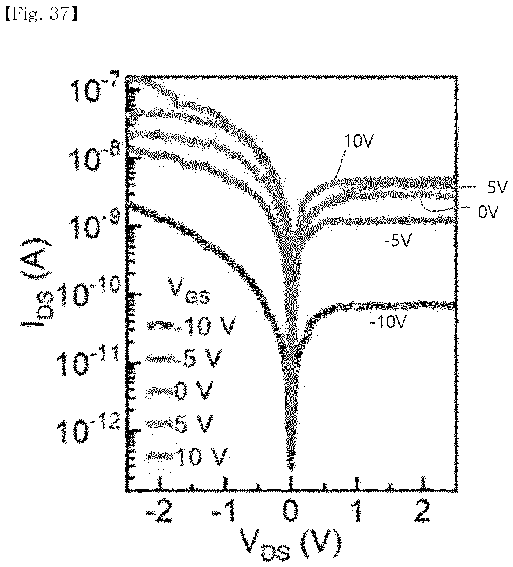

FIG. 35 is a view for explaining an on/off ratio of the Fe FET device according to the experimental example of the present invention, FIG. 36 is a view for explaining a memory window of the Fe FET device according to the experimental example of the present invention, and FIG. 37 is a view for explaining output characteristics of the Fe FET device according to the experimental example of the present invention.

Referring to FIG. 35, an on/off ratio (x $10^5$) according to the voltage $V_{GS}$ (V) of the Fe FET device according to the experimental example is measured and shown, and referring to FIG. 36, a memory window (V) according to the voltage $V_{GS}$ (V) of the Fe FET device according to the experimental example is measured and shown. As can be seen from FIGS. 35 and 36, the Fe FET device according to the experimental example has an on/off ratio and a memory window that linearly increase as the voltage increases. Accordingly, it can be seen that the Fe FET device according to the experimental example may control programmable performance and storage performance by controlling the gate voltage.

Referring to FIG. 37, the $I_{DS}$-$V_{DS}$ curve in units of 5 V for the gate voltage change from -10 V to +10 V. As can be seen from FIG. 37, as the gate voltage increases from -10 V to a positive value, the current gradually increases by about two times, which is consistent with transfer characteristics.

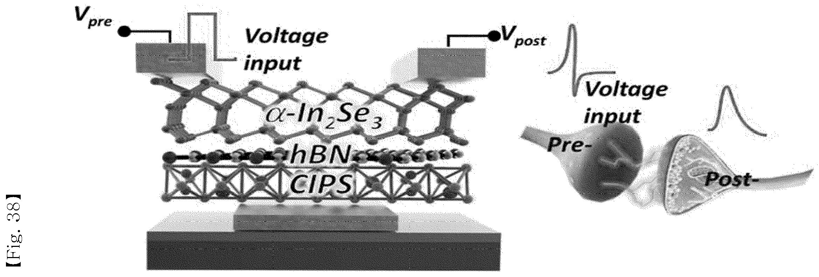

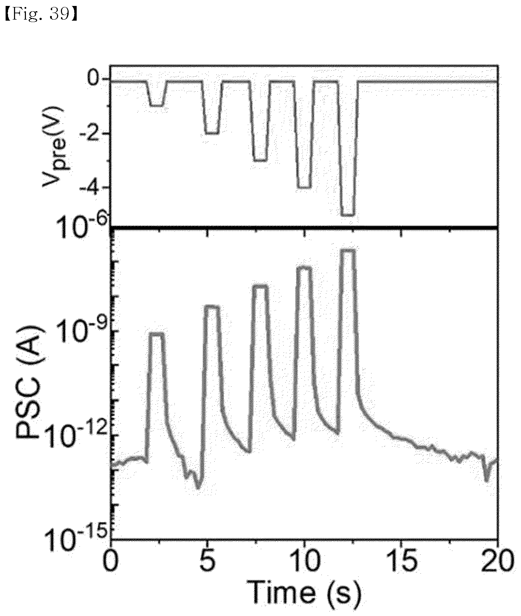

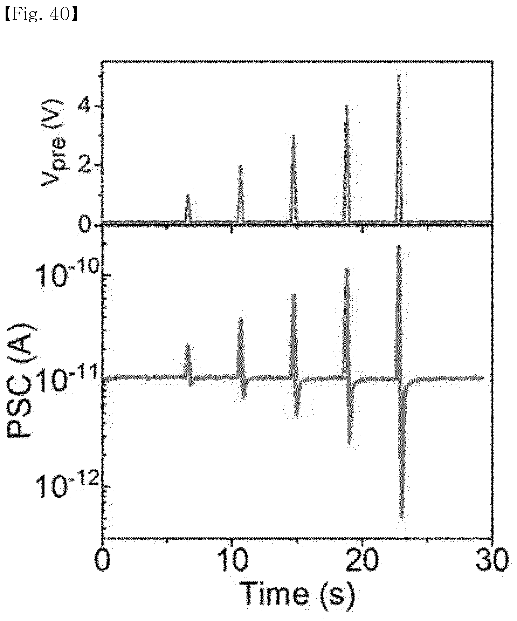

FIG. 38 is a view showing a schematic view of electrical synapse measurement using the Fe FET device according to the experimental example of the present invention, FIG. 39 is a view for explaining a short-term depression effect of the Fe FET device according to the experimental example of the present invention, and FIG. 40 is a view for explaining a short-term potentiation effect of the Fe FET device according to the experimental example of the present invention.

Referring to FIG. 39, it shows a short term potentiation (STP) effect simulated with a 0.2 V bias and an electric pulse (-1 V, -2 V, -3 V, -4 V, and -5 V) for reading the Fe FET device according to the experimental example.

As shown in FIG. 39, the PSC rapidly increases as the negative voltage pulse is applied, and the PSC rapidly decreases as the pulse is removed. In addition, it can be seen that the highest PSC value increases as the pulse amplitude increases. This effect may readily imitate the short term potentiation (STP) operation of the device.

Referring to FIG. 40, it shows a short term depression (STD) effect simulated with a -0.2 V bias and an electric pulse (+1 V, +2 V, +3 V, +4 V, and +5 V) for reading the Fe FET device according to the experimental example.

As can be seen from FIG. 40, the PSC value increases due to an action of the voltage pulse, and decreases to the lowest current level before returning to an initial state when the pulse is removed. This effect may readily imitate the short term depression (STD) operation of the device.

Experimental Example 5: Optical Signal Detection and Memory Conversion Characteristics of Fe FET Device

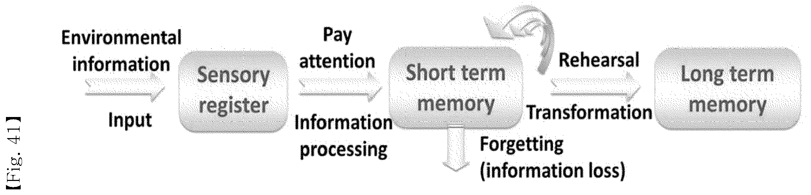

FIG. 41 is a view showing a model for signal detection and information memory processes.

Referring to FIG. 41, it shows a model showing conversion from short term memory (STM) to long term memory (LTM) when optical signal stimulation is input from the outside. More specifically, sensory memory may be generated from external optical stimulation, transferred to the short term memory (STM), and converted into the long term memory (LTM) through several rehearsals.

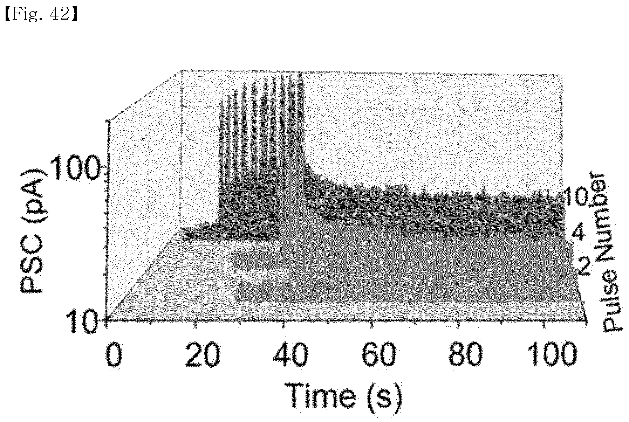

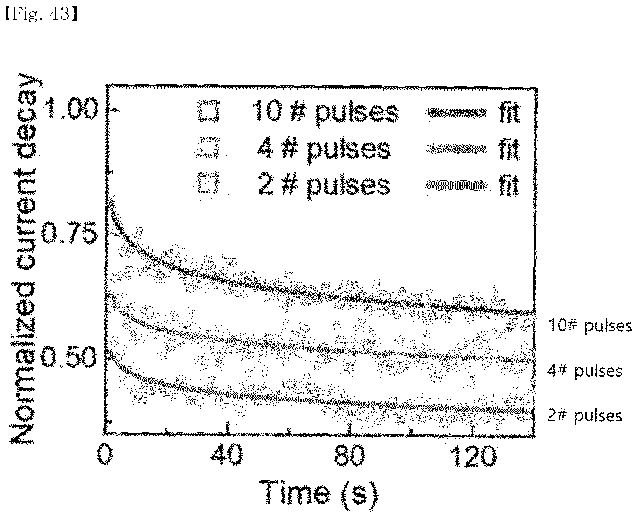

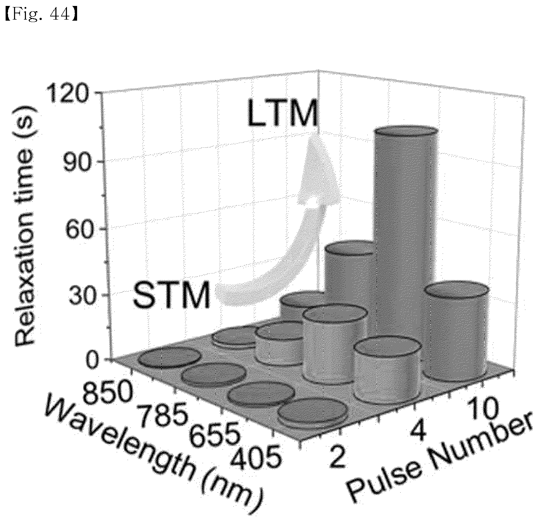

FIG. 42 is a view for explaining a current voltage according to the number of signals input to the Fe FET device according to the experimental example of the present invention, FIG. 43 is a view for explaining a normalized attenuation current value according to the number of signals input to the Fe FET device according to the experimental example of the present invention, and FIG. 44 is a view for explaining transition from a short term memory to a long term memory through the Fe FET device according to the experimental example of the present invention.

Referring to FIG. 42, it shows a change in a current value when light of a wavelength of 655 nm is repeatedly irradiated to the channel layer of the Fe FET device according to the experimental example for each pulse number. Referring to FIG. 43, it shows the normalized attenuation current extracted in FIG. 42. The memory state caused by the light pulse may be determined after analyzing the results of FIGS. 42 and 43 using a Kohlrausch elongation exponential function as shown in the following <Equation 1>. <Equation 1> represents a function for modeling a spontaneous retention loss.

$$<\text{Equation 1}>$$

$$M_t \sim \exp\left[-\left(\frac{t}{\tau}\right)^{\beta}\right]$$

($M_t$: Normalized current attenuation, t: Time, $\beta$: Stretch index with range from 0 to 1, $\tau$: Characteristic relaxation time)

Referring to FIG. 44, after fitting data, a characteristic relaxation time (s) is obtained and is expressed as a function of a wavelength (nm) and a pulse number. As can be seen from FIG. 44, when the number of pulses is increased from 2 to 10, the relaxation time $\tau$ is improved from 1.08 seconds to 102.2 seconds. Accordingly, it can be seen that information may be converted from the short term memory (STM) to long term memory (LTM) through rehearsal. In addition, it can be seen that the relaxation phenomenon is caused by a strong cohesive interaction between $\alpha$-In$_2$Se$_3$ dipoles induced by triggering multiple light pulses.

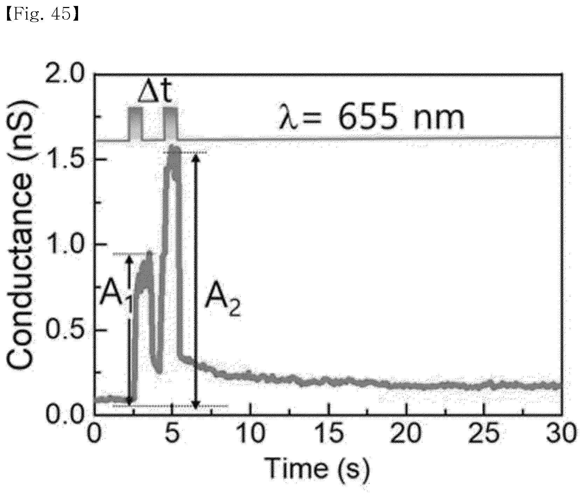

FIG. 45 is a view for explaining a PPF analysis result of the Fe FET device according to the experimental example of the present invention.

Referring to FIG. 45, it shows a change in the measured current value as a pair of lights having a wavelength of 655 nm and an intensity of 0.33 mW/cm$^2$ is irradiated to the channel layer of the Fe FET device according to the experimental example at time intervals of 1 second. A peak amplitude ratio of the second pulse $A_2$ and the first pulse $A_1$ in which the two continuous signals are received by the synapse is defined as a PPF ratio ($A_2/A_1$).

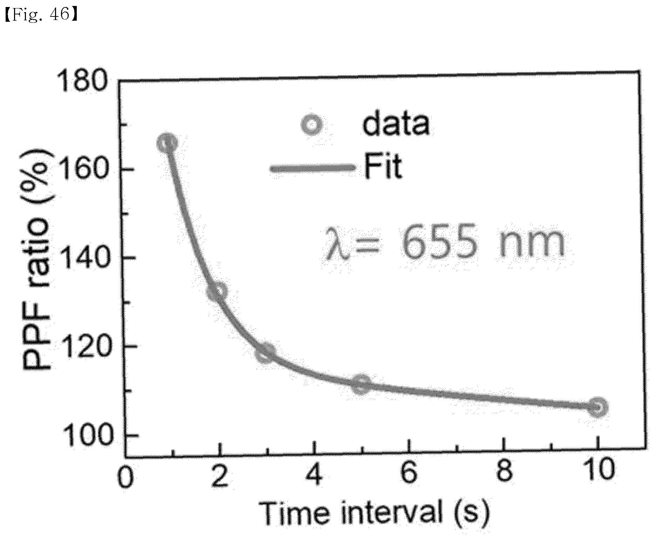

FIGS. 46 to 49 are views for explaining a PPF ratio of the Fe FET device according to the experimental example of the present invention.

Referring to FIG. 46, in the condition of FIG. 45, the change in the PPF ratio according to the time difference (time interval, s) between two input signals is shown. As can be seen from FIG. 46, a high PPF ratio of up to 170% is obtained for a time interval of 1 second. The high PPF ratio value means that the Fe FET device according to the experimental example may transfer residual information from the first signal to the second signal while minimizing an information loss.

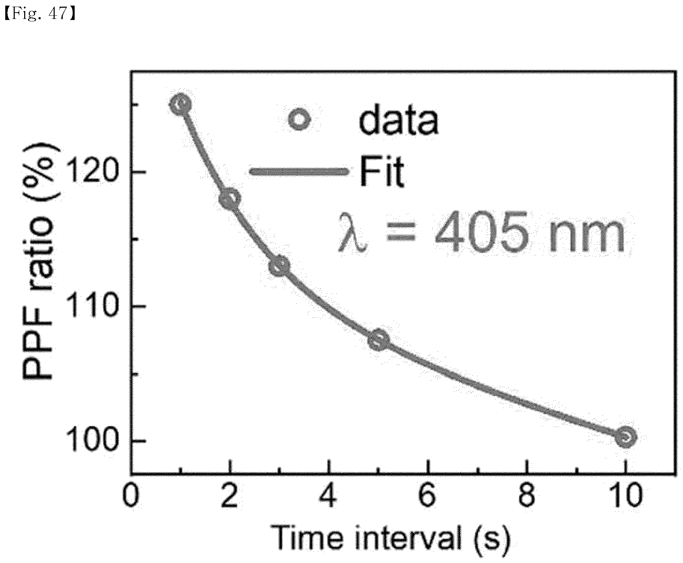

Referring to FIG. 47, it shows a change in the PPF ratio according to the time difference (time interval, s) between two input signals under the same condition as in FIG. 45 and a condition of a wavelength of 405 nm. As can be seen from FIG. 47, a PPF ratio of about 130% is obtained for a time interval of 1 second.

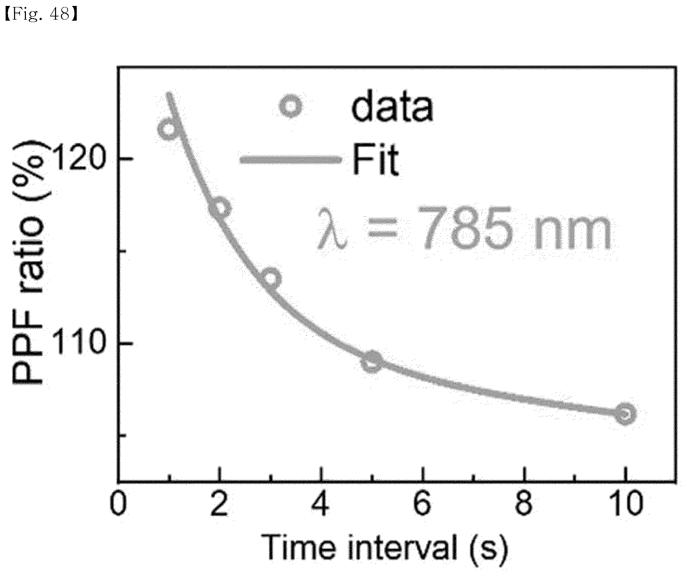

Referring to FIG. 48, it shows a change in the PPF ratio according to the time difference (time interval, s) between two input signals under the same condition as in FIG. 45 and a condition of a wavelength of 785 nm. As can be seen from FIG. 48, a PPF ratio of about 130% is obtained for a time interval of 1 second.

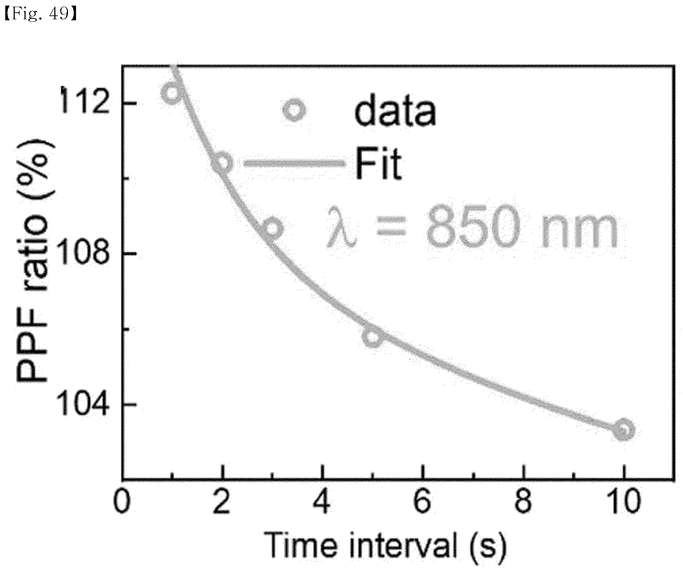

Referring to FIG. 49, it shows a change in the PPF ratio according to the time difference (time interval, s) between two input signals under the same condition as in FIG. 45 and a condition of a wavelength of 850 nm. As can be seen from FIG. 49, a PPF ratio of about 112% is obtained for a time interval of 1 second.

In addition, <Equation 2> capable of calculating a paired pulse facilitation (PPF) was derived based on the results of FIGS. 46 to 49. <Equation 2> represents a parameter indicating a degree of change of a synaptic weight when two continuous pulses are applied.

<Equation 2>

$$PPF = 1 + C_1 + \exp\left(-\frac{\Delta t}{\tau_1}\right) + C_2 + \exp\left(-\frac{\Delta t}{\tau_2}\right)$$

($C_1$: Initial acceleration size of fast collapse parameter, $C_2$: Initial acceleration size of slow collapse parameter, $\tau_1$: Characteristic relaxation time of fast collapse parameter, $\tau_2$: Characteristic relaxation time of slow collapse parameter, $\Delta t$: Time interval between first pulse and second pulse)

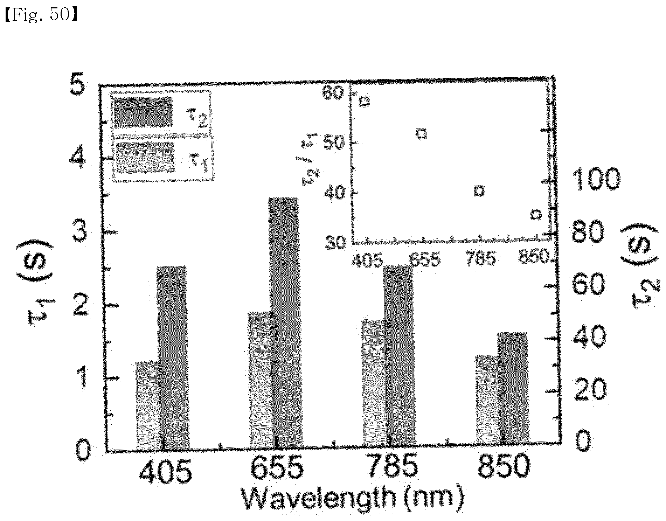

FIG. 50 is a view showing a fast relaxation time and a slow relaxation time of attenuation curves for various wavelengths.

Referring to FIG. 50, it shows the fast relaxation time $\tau_1$ and slow relaxation time $\tau_2$ of attenuation curves for mutually different wavelengths (405 nm, 655 nm, 785 nm, and 850 nm). The fast relaxation time $\tau_1$ and the slow relaxation time $\tau_2$ shown in FIG. 50 were derived through <Equation 2> described above.

Experimental Example 6: Optical Response Characteristics of Fe FET Device According to Electric Field

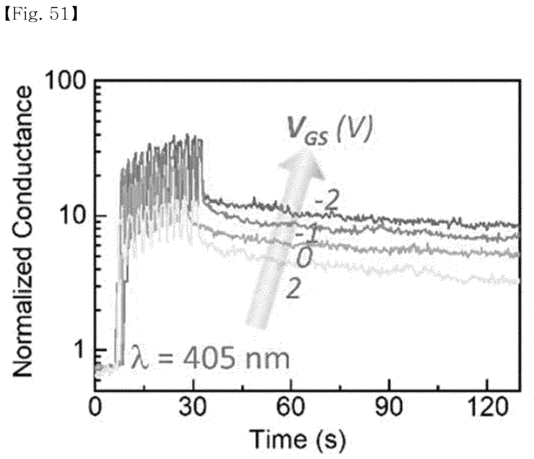

FIG. 51 is a view for explaining an effect of the electric field on the Fe FET device under a condition in which light having a wavelength of 405 nm is irradiated.

Referring to FIG. 51, 10 light pulses (wavelengths of 405 nm) each having an on/off time of 1 second are irradiated to the channel layer of the Fe FET device according to the experimental example, a voltage in a range of -2 V to +2 V is applied to the gate electrode, and then normalized conductance for a dark current is measured and shown.

As shown in FIG. 51, when a negative (-) voltage is applied to the gate electrode, the normalized conductance is higher than when a positive (+) voltage is applied to the gate electrode.

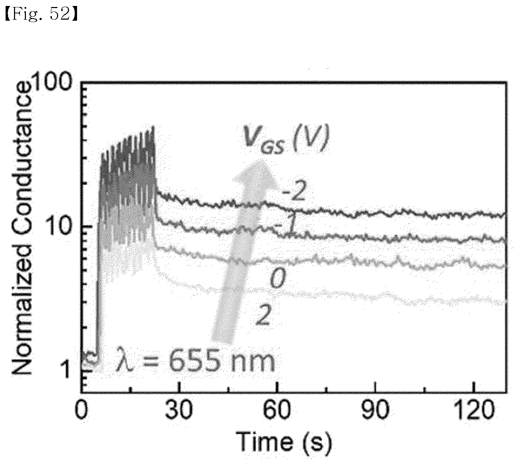

FIG. 52 is a view for explaining an effect of the electric field on the Fe FET device under a condition in which light having a wavelength of 655 nm is irradiated.

Referring to FIG. 52, 10 light pulses (wavelengths of 655 nm) each having an on/off time of 1 second are irradiated to the channel layer of the Fe FET device according to the experimental example, a voltage in a range of -2 V to +2 V is applied to the gate electrode, and then normalized conductance for a dark current is measured and shown.

As shown in FIG. 52, when a negative (-) voltage is applied to the gate electrode, the normalized conductance is higher than when a positive (+) voltage is applied to the gate electrode.

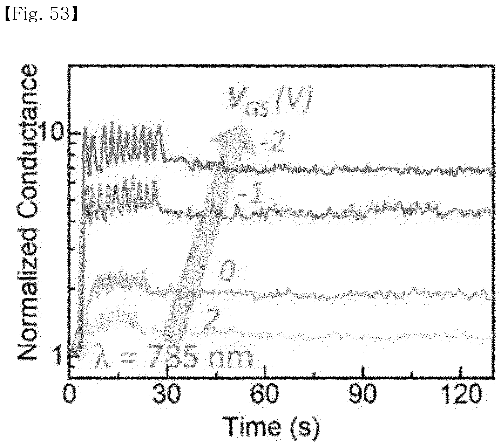

FIG. 53 is a view for explaining an effect of the electric field on the Fe FET device under a condition in which light having a wavelength of 785 nm is irradiated.

Referring to FIG. 53, 10 light pulses (wavelengths of 785 nm) each having an on/off time of 1 second are irradiated to the channel layer of the Fe FET device according to the experimental example, a voltage in a range of -2 V to +2 V is applied to the gate electrode, and then normalized conductance for a dark current is measured and shown.

As shown in FIG. 53, when a negative (-) voltage is applied to the gate electrode, the normalized conductance is higher than when a positive (+) voltage is applied to the gate electrode.

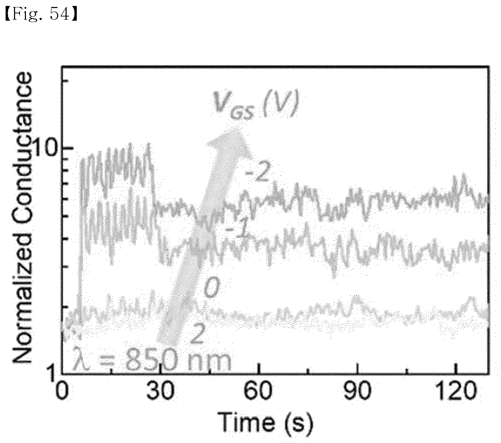

FIG. 54 is a view for explaining an effect of the electric field on the Fe FET device under a condition in which light having a wavelength of 850 nm is irradiated.

Referring to FIG. 54, 10 light pulses (wavelengths of 850 nm) each having an on/off time of 1 second are irradiated to the channel layer of the Fe FET device according to the experimental example, a voltage in a range of -2 V to +2 V is applied to the gate electrode, and then normalized conductance for a dark current is measured and shown.

As shown in FIG. 54, when a negative (-) voltage is applied to the gate electrode, the normalized conductance is higher than when a positive (+) voltage is applied to the gate electrode.

That is, as shown in FIGS. 51 to 54, the negative (-) gate voltage has a maximum response with respect to all wavelengths, as compared with the positive (+) gate voltage.

Experimental Example 7: Pattern Recognition Using Optical Potentiation and Electrical Depression of Fe FET Device

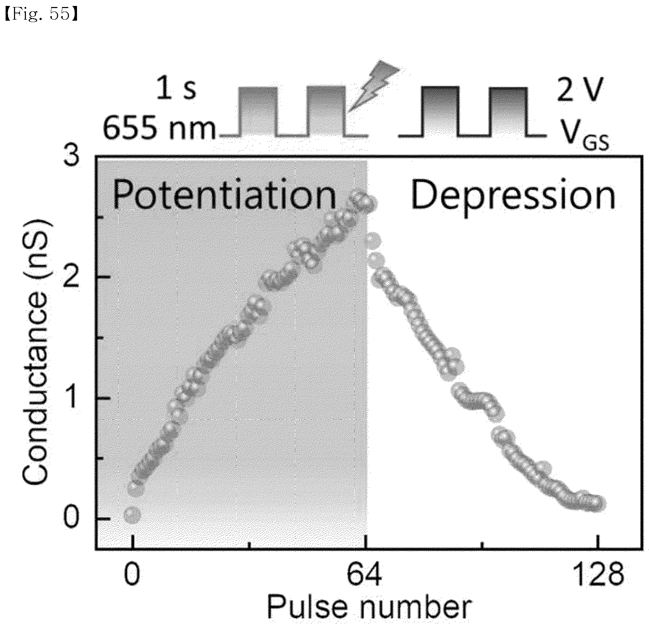

FIGS. 55 to 58 are views for explaining synaptic weight update characteristics of the Fe FET device according to the experimental example of the present invention.

Referring to FIG. 55, in order to update a synaptic weight of the Fe FET device according to the experimental example, an optical pulse (wavelength of 655 nm) having a pulse width of 1 second is continuously irradiated to control the polarization of the channel layer ($\alpha$-In$_2$Se$_3$), thereby potentiating the device. Thereafter, the light pulse was removed and a continuous positive voltage with an amplitude of +2 V was applied to the gate electrode to re-arrange the dipoles to initial conditions, thereby depressing the device. All optical pulses and electrical pulses were used in groups of 64 and a read voltage $V_{DS}$ was controlled to be 0.2 V.

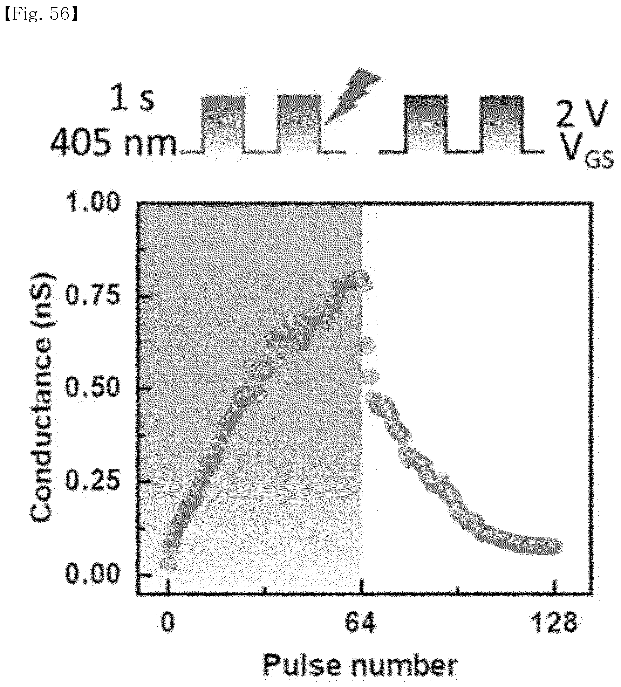

Referring to FIG. 56, in order to update a synaptic weight of the Fe FET device according to the experimental example, an optical pulse (wavelength of 405 nm) having a pulse width of 1 second is continuously irradiated to control the polarization of the channel layer ($\alpha$-In$_2$Se$_3$), thereby potentiating the device. Thereafter, the light pulse was removed and a continuous positive voltage with an amplitude of +2 V was applied to the gate electrode to re-arrange the dipoles to initial conditions, thereby depressing the device. All optical pulses and electrical pulses were used in groups of 64 and a read voltage $V_{DS}$ was controlled to be 0.2 V.

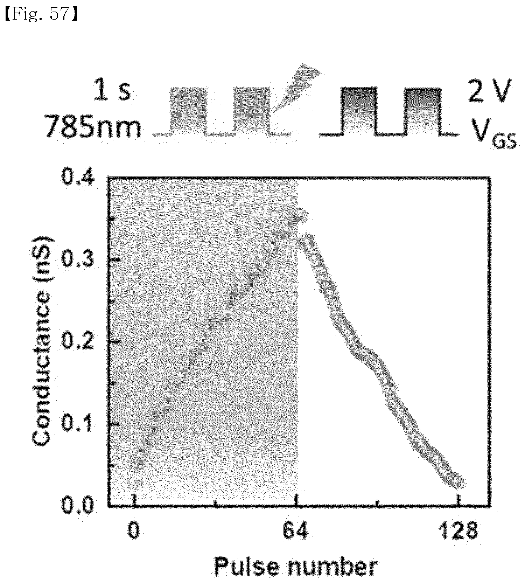

Referring to FIG. 57, in order to update a synaptic weight of the Fe FET device according to the experimental example, an optical pulse (wavelength of 785 nm) having a pulse width of 1 second is continuously irradiated to control the polarization of the channel layer ($\alpha$-In$_2$Se$_3$), thereby potentiating the device. Thereafter, the light pulse was removed and a continuous positive voltage with an amplitude of +2 V was applied to the gate electrode to re-arrange the dipoles to initial conditions, thereby depressing the device. All optical pulses and electrical pulses were used in groups of 64 and a read voltage $V_{DS}$ was controlled to be 0.2 V.

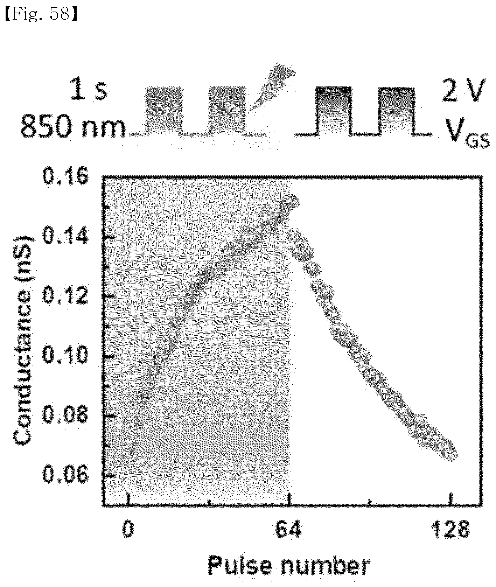

Referring to FIG. 58, in order to update a synaptic weight of the Fe FET device according to the experimental example, an optical pulse (wavelength of 850 nm) having a pulse width of 1 second is continuously irradiated to control the polarization of the channel layer ($\alpha$-In$_2$Se$_3$), thereby potentiating the device. Thereafter, the light pulse was removed and a continuous positive voltage with an amplitude of +2 V was applied to the gate electrode to re-arrange the dipoles to initial conditions, thereby depressing the device. All optical pulses and electrical pulses were used in groups of 64 and a read voltage $V_{DS}$ was controlled to be 0.2 V.

As shown in FIGS. 55 to 58, the Fe FET device according to the experimental example is potentiated by the optical signal, whereas the Fe FET device according to the experimental example is depressed by the electrical signal. In addition, it can be seen that the Fe FET device according to the experimental example has synaptic weight update characteristics essential for the development of a human neural network (HNN).

Moreover, the synaptic weight is updated through the following <Equation 3> and <Equation 4>. More specifically, <Equation 3> may be used to calculate nonlinearity in an LTP curve, and <Equation 4> may be used to calculate nonlinearity in an LTD curve.

<Equation 3>

$$G_P = G_{n+1} - G_n = B\left(1 - e^{-n/A_P}\right) + G_{min}$$

($G_P$: Conductance in potentiation state, $G_n$: Current conductance, $G_{n+1}$: Updated conductance, $G_{min}$: Minimum conductance, $A_P$: Nonlinearity factor for potentiation range, B: Fitting constant for normalizing conductance range, n: Number of applied pulses)

<Equation 4>

$$G_D = G_{n+1} - G_n = \Delta G \downarrow = -B\left(1 - e^{(n-n_{max})/A_D}\right) + G_{max}$$

($G_D$: Conductance in depression state, $G_n$: Current conductance, $G_{n+1}$: Updated conductance, $G_{min}$: Maximum conductance, $A_D$: Nonlinearity factor for depression range, B: Fitting constant for normalizing conductance range, n: Number of applied pulses, $n_{max}$: Maximum value of number of applied pulses)

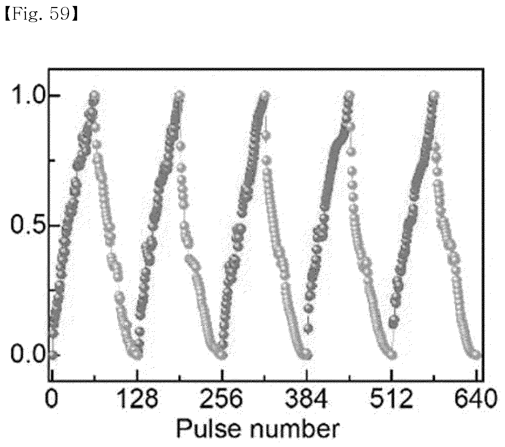

FIG. 59 is a view for explaining long-term stability for the synaptic weight update characteristics of the Fe FET device according to the experimental example of the present invention.

Referring to FIG. 59, the Fe FET device according to the experimental example was potentiated by irradiating light, an operation of applying a gate voltage and depressing the gate voltage was set to 1 cycle, and then a change during 5 cycles of continuous operation was measured. As can be seen from FIG. 59, the stable potentiation and depression were performed even in 5 cycles of continuous operation.

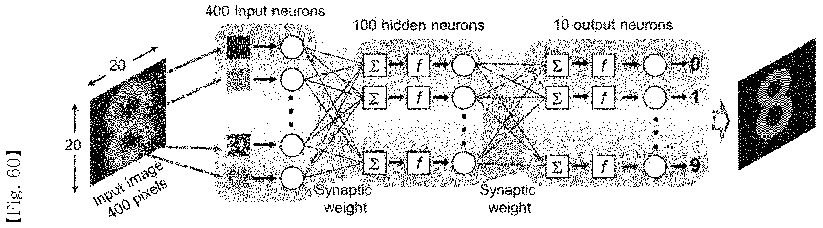

FIG. 60 is a schematic view of an ANN for recognizing a MNIST pattern.

Referring to FIG. 60, it shows a schematic view of an ANN based on single layer perceptron for recognizing a MNIST pattern. The ANN consists of 400 input neurons, 100 hidden neurons, and 10 output neurons, and a MNIST dataset is image data consisting of 400 pixels from 0 to 10.

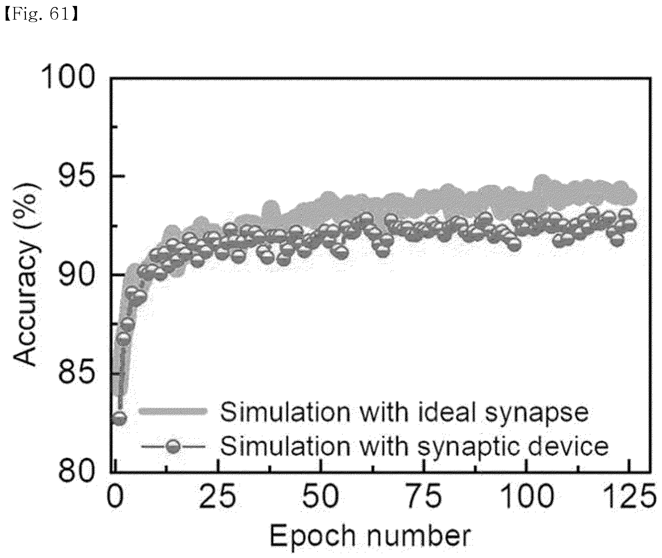

FIG. 61 is a view for explaining pattern recognition accuracy according to Epoch.

Referring to FIG. 61, it shows a result in which 8,000 images are randomly selected from among 60,000 images to train the same, and then pattern recognition simulation is performed using 10,000 image data sets. Specifically, a gray line represents a simulation result for the ideal synapse device (simulation with ideal synaptic device), and a red line represents a simulation result for the Fe FET device (simulation with ideal synaptic device) according to the experimental example. As can be seen from FIG. 61, after 125 epoch, the accuracy of 94% was obtained in the case of the ideal synapse device, and the accuracy of 92.5% was obtained in the case of the Fe FET device according to the experimental example. Accordingly, it can be seen that the Fe FET device according to the experimental example is similar to a reaction of an ideal system for forming artificial neural networks (ANN).

Experimental Example 8: Light Adaptation Test of Fe FET Device

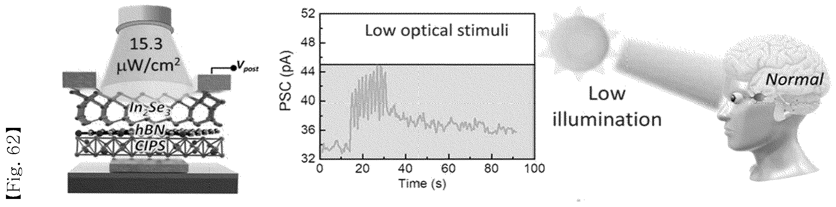

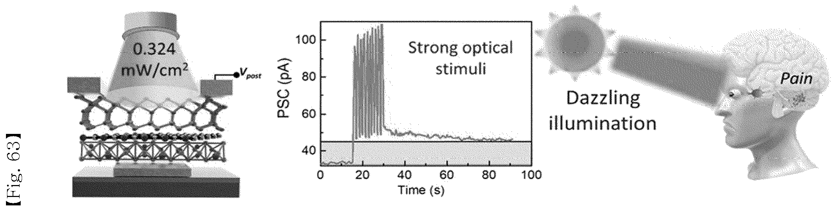

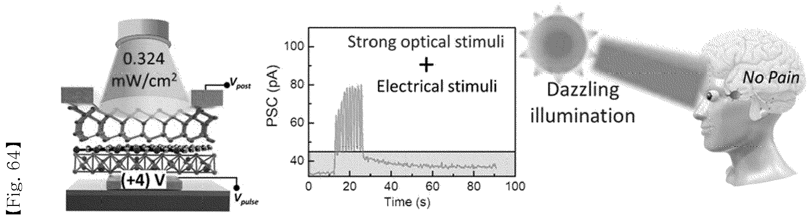

FIG. 62 is a view for explaining a light adaptation test result when a weak light stimulation is applied, FIG. 63 is a view for explaining a light adaptation test result when a strong light stimulation is applied, and FIG. 64 is a view for explaining a light adaptation test result when the strong light stimulation and electrical stimulation are applied.

Referring to FIG. 62, the current value measured when the light intensity is low (15.3 $\mu$W/cm$^2$, 1 second width, 655 nm wavelength) is lower than the threshold current value (about 45 pA). Referring to FIG. 63, the current value measured when the light intensity is high (0.324 mW/cm$^2$) is higher than the threshold current value. This is similar to a situation in which the iris does not work properly and the retina is caught in external lighting.

In order to prevent a high current from flowing through the device due to such high-intensity optical illumination, as shown in FIG. 64, the current value measured by applying a positive voltage (+4 V) pulse to the gate electrode to adjust a modulating synapse function was controlled to be equal to or less than the threshold current value. This phenomenon shows a realistic imitating of biological eyes, and this technology may be applied to develop a brain-inspired neural network.

Experimental Example 9: Logic Operation of Fe FET Device

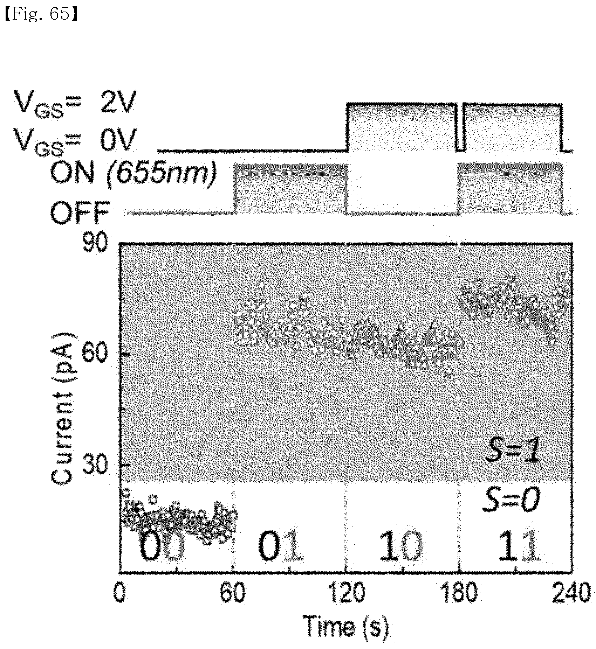

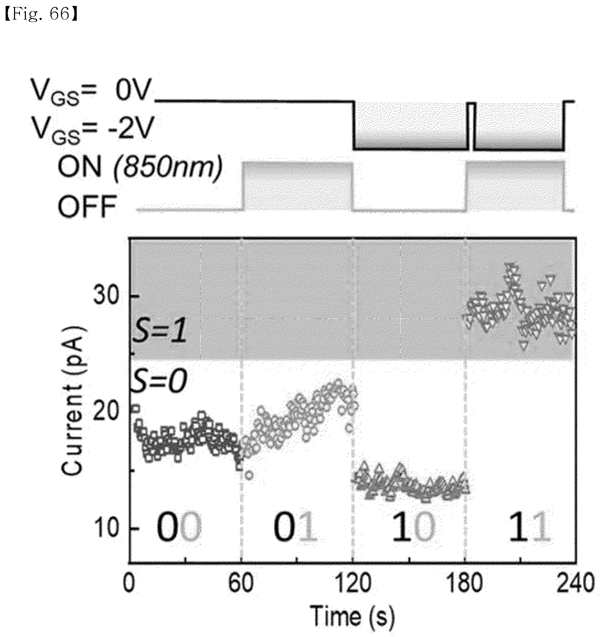

FIG. 65 is a view showing an OR logic operation according to a change in an optical signal and a change in an electrical signal, and FIG. 66 is a view showing an AND logic operation according to a change in an optical signal and a change in an electrical signal.

Referring to FIGS. 65 and 66, logic operations such as "OR" and "AND" functions were implemented through optical signal changes and electrical signal changes. More specifically, light of wavelengths of 655 nm and 850 nm was used as optical spikes for the optical input signal. Simultaneously, electrical pulses of +2 V and -2 V were applied to the gate electrode as electrical inputs to perform the "OR" and "AND" operations, respectively. $V_{DS}$ of 0.2 V ($V_{DS}$ = 0.2 V) was used as the read voltage, and both operations were performed with the same threshold current value (25 pA). Current magnitudes above and below the threshold level may be considered to be a "1" (S = 1) and a "0" (S = 0) state, respectively. Accordingly, the logic functions of "OR" and "AND" were modulated according to the input optical signal and determined by the electrical spike of the gate electrode. In addition, the Fe FET device according to the experimental example shows an optical logic operation, which is another step for performing an in-memory calculation in a single device.

Experimental Example 10: Multi State of Fe FET Device

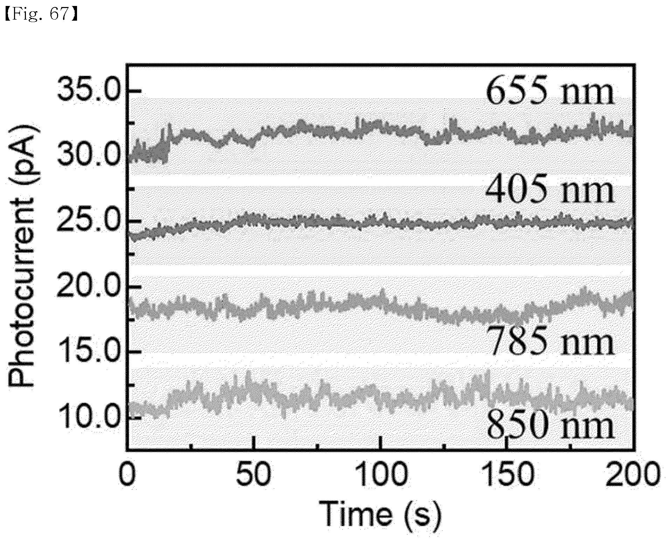

FIG. 67 is a view for explaining multi-state characteristics of the Fe FET device according to the experimental example of the present invention.

Referring to FIG. 67, the Fe FET device according to the experimental example is irradiated with light having four mutually different wavelengths (655 nm, 405 nm, 785 nm, and 850 nm), and current values measured for each wavelength are shown. As can be seen in FIG. 67, four mutually different current values appear when the light of four mutually different wavelengths (655 nm, 405 nm, 785 nm, and 850 nm) is irradiated. Accordingly, it can be seen that the Fe FET device according to the experimental example has multi-state characteristics. In addition, it can be predicted that more logic functions such as "XOR" and "NAND" as well as "OR" and "AND" may be implemented if light of various wavelengths and electrical signals are used together.

Experimental Example 11: Pavlov's Dog Experiment of Fe FET Device

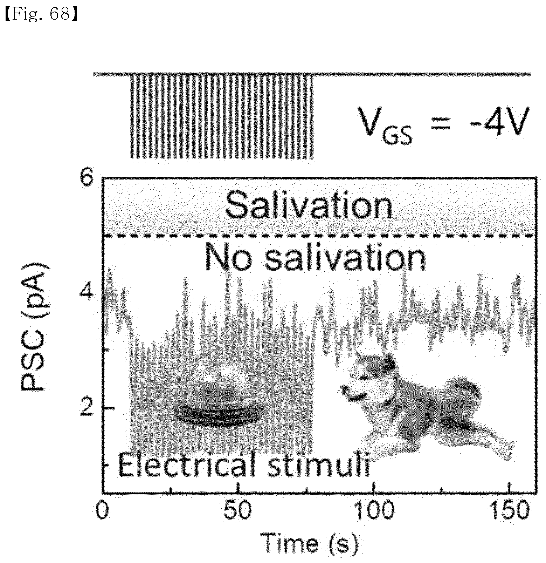

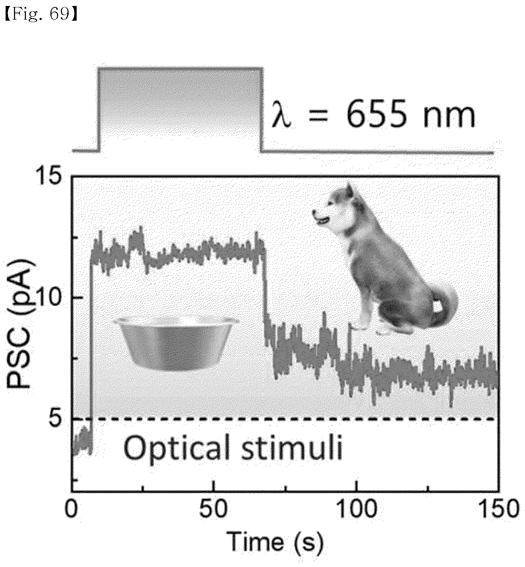

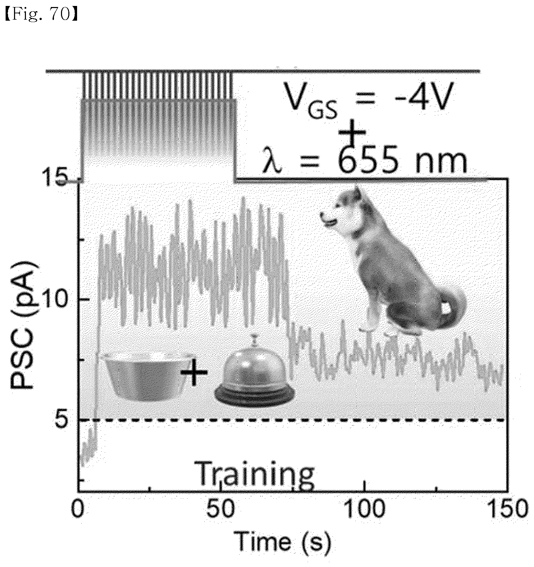

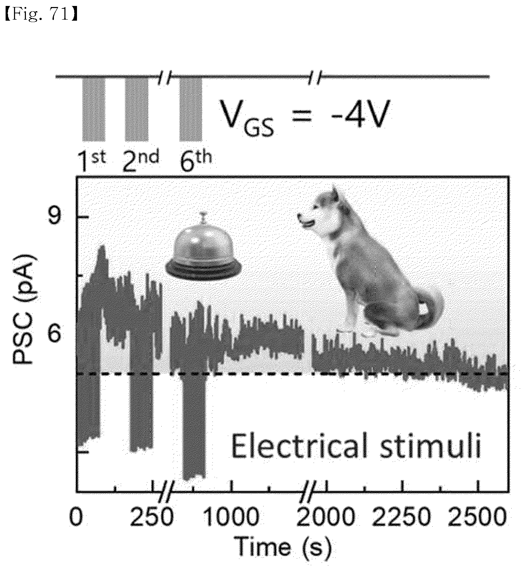

FIG. 68 is a view showing a current value when conditional stimulation is applied, FIG. 69 is a view showing a current value when unconditional stimulation is applied, FIG. 70 is a view showing a current value when the conditional stimulation and the unconditional stimulation are simultaneously applied, and FIG. 71 is a view showing a current value when only the conditional stimulation is applied after training.

Referring to FIG. 68, it shows a current value when conditional stimulation (ringing, pulse voltage applied to the gate electrode) is applied. Since the current value is lower than the threshold value, this means no salivary secretion. Referring to FIG. 69, it shows a current value when unconditional stimulation (food, light irradiated to the channel layer) is applied. Since the current value is higher than the threshold value, this means salivary secretion. Referring to FIG. 70, since the current value is higher than the threshold value, this means that saliva is secreted when the conditional stimulation and the unconditional stimulation are simultaneously applied. Referring to FIG. 71, since the current value is higher than the threshold value, this means that saliva is secreted just by applying the conditional stimulation after training.

More specifically, when one of conditional events occurs after successful training among events occurring at the same time, another event is recalled from memory. In this case, optical stimulation such as food (unconditioned stimulation), was regarded as visual information and imitated using electric pulses. In order to imitate bell-sound motion, 30 electrical pulses of amplitude -4 V and width of 1 s were applied (FIG. 68), and conditional stimulation alone demonstrated that it was not effective in inducing salivary secretion with currents below a threshold level (5 pA). In contrast, unconditional stimulation (light pulses with a wavelength of 655 nm, intensity of 0.33 mW/cm$_2$, and width of 50 s) may cause salivary secretion, which means that a current above the threshold level is passing through the device (FIG. 69). FIG. 70 shows a process of in which a conditional event and an unconditional event occur simultaneously. The current passing through the device during training was much higher than the threshold level, which indicates reflections between the optical stimulation and the electrical stimulation were established as associated events. Once the training is completed, only conditional stimulation (electric pulses) may induce high currents (equal to or greater than the threshold level) passing through the device, and the sensation is maintained for a long time. FIG. 71 shows recognition of this event by repeatedly applying the electric pulse every 200 seconds. It can be seen that the Fe FET device according to the experimental example may have information of 2400 seconds or longer.

While the present invention has been described in connection with the embodiments, it is not to be limited thereto but will be defined by the appended claims. In addition, it is to be understood that those skilled in the art can substitute, change or modify the embodiments in various forms without departing from the scope and spirit of the present invention.

**Claims**

**1.** A method for manufacturing a heterojunction structure device, the method comprising:

preparing a substrate;
forming a gate electrode on the substrate;
forming a ferroelectric layer including a material having ferroelectric characteristics on the gate electrode;
forming an insulating layer on the ferroelectric layer;
forming a channel layer including a material having ferroelectric and semiconductor characteristics on the insulating layer; and
forming a source electrode and a drain electrode on the channel layer such that the source electrode and the drain electrode are spaced apart from each other.

2. The method for manufacturing a heterojunction structure device of claim 1, wherein the ferroelectric layer includes a material having out-of-plane (OOP) polarization characteristics.

3. The method for manufacturing a heterojunction structure device of claim 1, wherein the channel layer includes a material having both out-of-plane (OOP) polarization characteristics and in-plane (IP) polarization characteristics.

4. The method for manufacturing a heterojunction structure device of claim 1, wherein the ferroelectric layer includes any one of hafnium zirconium oxide (HZO), arsenic (As), antimony (Sb), bismuth (Bi), tellurium (Te), d1T-MoS2, t-MoS2, WS2, WSe2, WTe2, BiN, SbN, BiP, GaN, GaSe, SiC, BN, AIN, ZnO, GeS, GeSe, SnS, SnSe, SiTE, GeTe, SnTE, PbTe, CrN, CrB2, CrBr3, Crl3, GaTeCl, AgBiP2Se6, CuCrP2S6, CuCrP2Se6, CuVP2S6, CuVP2Se6, CuInP2Se6, CuInP2S6(CIPS), Sc2CO2, Bi2O2Se, Bi2O2Te, Bi2O2s, Ba2PbCl4, graphanol, hydroxyl-functionalized graphene, halogen-decorated phosphorene, g-C6N8H, and Bi-CH2OH.

5. The method for manufacturing a heterojunction structure device of claim 1, wherein the channel layer includes any one of alpha-indium selenide ($\alpha$-In2Se3), 1T-MoS2, MoSSe, MoTe, SnS, SnSe, SnTe, GeS, GeSe, and GeTe.

6. The method for manufacturing a heterojunction structure device of claim 1, wherein polarization of the channel layer is controlled by light irradiated to the channel layer.

7. The method for manufacturing a heterojunction structure device of claim 1, wherein polarization of the ferroelectric layer is controlled by a voltage applied to the gate electrode.

8. The method for manufacturing a heterojunction structure device of claim 1, wherein the insulating layer includes aluminum oxide (Al2O3), silicon oxide (SiO2), hafnium oxide (HfO2), and hexagonal boron nitride (h-BN).

【Fig. 1】

```
                    ┌─────────────┐
                    │    Start    │
                    └──────┬──────┘
                           │
                           ▼
        ┌──────────────────────────────────────┐
        │         Preparing substrate          │────S110
        └──────────────────┬───────────────────┘
                           │
                           ▼
        ┌──────────────────────────────────────┐
        │    Forming gate electrode on substrate│────S120
        └──────────────────┬───────────────────┘
                           │
                           ▼
        ┌──────────────────────────────────────┐
        │  Forming ferroelectric layer including│
        │  material having ferroelectric        │────S130
        │  characteristics on gate electrode    │
        └──────────────────┬───────────────────┘
                           │
                           ▼
        ┌──────────────────────────────────────┐
        │ Forming insulating layer on           │────S140
        │ ferroelectric layer                   │
        └──────────────────┬───────────────────┘
                           │
                           ▼
        ┌──────────────────────────────────────┐
        │ Forming channel layer including       │
        │ material having ferroelectric and     │────S150
        │ semiconductor characteristics on      │
        │ insulating layer                      │
        └──────────────────┬───────────────────┘
                           │
                           ▼
        ┌──────────────────────────────────────┐
        │ forming source electrode and drain    │
        │ electrode on channel layer such that  │────S160
        │ source electrode and drain electrode  │
        │ are spaced apart from each other      │
        └──────────────────┬───────────────────┘
                           │
                           ▼
                    ┌─────────────┐
                    │     End     │
                    └─────────────┘
```

【Fig. 2】

S110

S120

【Fig. 3】

S130

```
                              200

                         ⎱ 120 ⎱
                         ⎰ 110 ⎰ 100
```

⬇

S140

```
                         400

                         300

                         200

                         ⎱ 120 ⎱
                         ⎰ 110 ⎰ 100
```

【Fig. 4】

S150

500
400
300
200
120
110
100

【Fig. 5】

S160

【Fig. 6】

S210

【Fig. 7】

S220

【Fig. 8】

S230

【Fig. 9】

S340

【Fig. 10】

S350

【Fig. 11】

S360

【Fig. 12】

S370

【Fig. 13】

【Fig. 14】

【Fig. 15】

【Fig. 16】

【Fig. 17】

【Fig. 18】

【Fig. 19】

【Fig. 20】

【Fig. 21】

【Fig. 22】

【Fig. 23】

【Fig. 24】

【Fig. 25】

【Fig. 26】

【Fig. 27】

【Fig. 28】

【Fig. 29】

【Fig. 30】

【Fig. 31】

【Fig. 32】

【Fig. 33】

【Fig. 34】

【Fig. 35】

【Fig. 36】

【Fig. 37】

【Fig. 38】

【Fig. 39】

EP 4 567 897 A1

【Fig. 40】

59

【Fig. 41】

【Fig. 42】

【Fig. 43】

【Fig. 44】

【Fig. 45】

【Fig. 46】

【Fig. 47】

【Fig. 48】

【Fig. 49】

【Fig. 50】

【Fig. 51】

【Fig. 52】

【Fig. 53】

【Fig. 54】

【Fig. 55】

【Fig. 56】

【Fig. 57】

【Fig. 58】

【Fig. 59】

【Fig. 60】

【Fig. 61】

【Fig. 62】

【Fig. 63】

【Fig. 64】

【Fig. 65】

【Fig. 66】

【Fig. 67】

【Fig. 68】

【Fig. 69】

【Fig. 70】

【Fig. 71】

| | Europäisches Patentamt<br>European Patent Office<br>Office européen des brevets | **EUROPEAN SEARCH REPORT** | **Application Number**<br>EP 24 18 0793 |
|---|---|---|---|

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>Y | CN 116 613 213 A (INST MICROELECTRONICS CAS) 18 August 2023 (2023-08-18)<br>* figs. 1, 3a, 3b and the associated description * | 1,4,5,7,8<br>2,3,6 | INV.<br>H01L29/24<br>H01L29/66<br>H01L29/51<br>H01L29/78 |
| Y | JIAO HANXUE ET AL: "Ferroelectric field effect transistors for electronics and optoelectronics",<br>APPLIED PHYSICS REVIEWS, AMERICAN INSTITUTE OF PHYSICS, 2 HUNTINGTON QUADRANGLE, MELVILLE, NY 11747,<br>vol. 10, no. 1,<br>23 February 2023 (2023-02-23),<br>XP012272587,<br>DOI: 10.1063/5.0090120<br>[retrieved on 2023-02-23]<br>* page 3 *<br>* page 11 * | 2,3,6 | H01L31/113 |
| A | CHEN LI ET AL: "Ferroelectric memory based on two-dimensional materials for neuromorphic computing",<br>NEUROMORPHIC COMPUTING AND ENGINEERING, [Online]<br>vol. 2, no. 2, 1 June 2022 (2022-06-01),<br>page 022001, XP093206945,<br>ISSN: 2634-4386, DOI:<br>10.1088/2634-4386/ac57cb<br>Retrieved from the Internet:<br>URL:https://iopscience.iop.org/article/10.1088/2634-4386/ac57cb/pdf><br>[retrieved on 2024-11-18]<br>* figs. 7, 9 and the associated description;<br>table II * | 1-8 | |

**TECHNICAL FIELDS SEARCHED (IPC)**

H01L
H10B

-/--

The present search report has been drawn up for all claims

| Place of search | Date of completion of the search | Examiner |
|---|---|---|
| Munich | 25 November 2024 | Nesso, Stefano |

EPO FORM 1503 03.82 (P04C01)

page 1 of 2

Europäisches
Patentamt
European
Patent Office
Office européen
des brevets

**EUROPEAN SEARCH REPORT**

**Application Number**

EP 24 18 0793

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | BIAN JIHONG ET AL: "Neuromorphic computing: Devices, hardware, and system application facilitated by two-dimensional materials", APPLIED PHYSICS REVIEWS, AMERICAN INSTITUTE OF PHYSICS, 2 HUNTINGTON QUADRANGLE, MELVILLE, NY 11747, vol. 8, no. 4, 28 October 2021 (2021-10-28), XP012260722, DOI: 10.1063/5.0067352 [retrieved on 2021-10-28] * table I * | 1-8 | |
| A | SHENMAO LIN ET AL: "Recent Advances in Layered Two-Dimensional Ferroelectrics from Material to Device", ADVANCED FUNCTIONAL MATERIALS, WILEY - V C H VERLAG GMBH & CO. KGAA, DE, vol. 33, no. 42, 20 June 2023 (2023-06-20) , page n/a, XP072521505, ISSN: 1616-301X, DOI: 10.1002/ADFM.202304139 * page 2 - page 4; figure 6 * | 1-8 | |
| A | WENJUAN CI ET AL: "All-In-One Optoelectronic Neuristor Based on Full-vdW Two-Terminal Ferroelectric p-n Heterojunction", ADVANCED FUNCTIONAL MATERIALS, WILEY - V C H VERLAG GMBH & CO. KGAA, DE, vol. 34, no. 15, 23 July 2023 (2023-07-23) , page n/a, XP072617149, ISSN: 1616-301X, DOI: 10.1002/ADFM.202305822 * fig. 4 and the associated description * | 1-8 | |

TECHNICAL FIELDS SEARCHED (IPC)

The present search report has been drawn up for all claims

| Place of search | Date of completion of the search | Examiner |
|---|---|---|
| Munich | 25 November 2024 | Nesso, Stefano |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 18 0793

This annex lists the patent family members relating to the patent documents cited in the above-mentioned European search report.
The members are as contained in the European Patent Office EDP file on
The European Patent Office is in no way liable for these particulars which are merely given for the purpose of information.

25-11-2024

| Patent document cited in search report | Publication date | Patent family member(s) | Publication date |
|---|---|---|---|
| CN 116613213 A | 18-08-2023 | NONE | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **DUTTA, D** ; **MUKHERJEE, S** ; **UZHANSKY, M** ; **KOREN, E**. Cross-field optoelectronic modulation via inter-coupled ferroelectricity in 2D In2Se3.. *npj 2D Materials and Applications*, 2021
- **RUBIO-MARCOS, F** ; **OCHOA, D. A** ; **DEL CAMPO, A** ; **GARCIA, M. A** ; **CASTRO, G. R** ; **FERNANDEZ, J. F** ; **GARCIA, J. E.** Reversible optical control of macroscopic polarization in ferroelectrics.. *Nature Photonics*, 2017
- **XUE, F** ; **HE, X** ; **LIU, W** ; **PERIYANAGOUNDER, D** ; **ZHANG, C** ; **CHEN, M.** ; **LIN, C. H** ; **LUO, L** ; **YENGEL, E** ; **TUNG, V et al.** Optoelectronic Ferroelectric Domain-Wall Memories Made from a Single Van Der Waals Ferroelectric.. *Advanced Functional Materials*, 2020

- **DUTTA, D.** ; **MUKHERJEE, S.** ; **UZHANSKY, M.** ; **KOREN, E.** Cross-field optoelectronic modulation via inter-coupled ferroelectricity in 2D In2Se3.. *npj 2D Materials and Applications*, 2021, vol. 5 (1)
- **RUBIO-MARCOS, F** ; **OCHOA, D. A** ; **DEL CAMPO, A** ; **GARCIA, M. A.** ; **CASTRO, G. R** ; **FERNANDEZ, J. F** ; **GARCIA, J. E.** Reversible optical control of macroscopic polarization in ferroelectrics.. *Nature Photonics*, 2017, vol. 12 (1), 29-32
- **XUE, F** ; **HE, X** ; **LIU, W.** ; **PERIYANAGOUNDER, D.** ; **ZHANG, C** ; **CHEN, M** ; **LIN, C. H.** ; **LUO, L** ; **YENGEL, E.** ; **TUNG, V. et al.** Optoelectronic Ferroelectric Domain-Wall Memories Made from a Single Van Der Waals Ferroelectric.. *Advanced Functional Materials*, 2020, vol. 30 (52)